# EUROPÄISCHE PATENTSCHRIFT

(11) **EP 1 888 820 B1**
(45) Veröffentlichungstag und Bekanntmachung des Hinweises auf die Patenterteilung: **13.10.2010**
(21) Anmeldenummer: 06743058.7
(22) Anmeldetag: 24.05.2006
(51) Int. Cl.: C25D 17/06, C25D 17/28, H05K 3/00

(54) **VERFAHREN, KLAMMER UND VORRICHTUNG ZUM TRANSPORT EINES BEHANDLUNGSGUTES IN EINER ELEKTROLYSEANLAGE**
METHOD, CLIP AND DEVICE FOR TRANSPORTING AN ARTICLE TO BE TREATED IN AN ELECTROLYTIC SYSTEM
PROCEDE, PINCE ET DISPOSITIF POUR TRANSPORTER UN PRODUIT A TRAITER DANS UNE INSTALLATION D'ELECTROLYSE

(30) Priorität: 25.05.2005 DE 102005024102
(43) Veröffentlichungstag der Anmeldung: 20.02.2008
(73) Patentinhaber: ATOTECH Deutschland GmbH, 10553 Berlin (DE)
(72) Erfinder: SCHELLER, Britta, 90518 Altdorf (DE); SCHMIDT, Rainer, 91126 Kammerstein (DE); LORENZ, Olaf, 90518 Altdorf (DE)
(74) Vertreter: Banzer, Hans-Jörg
(86) Internationale Anmeldenummer: PCT/EP2006/004965
(87) Internationale Veröffentlichungsnummer: WO 2006/125629

(56) Entgegenhaltungen:
- EP-A- 0 254 962
- EP-A- 0 561 184
- WO-A-99/10568
- DE-A1- 3 624 481
- US-A- 5 755 935

## Beschreibung

Die vorliegende Erfindung betrifft ein Verfahren, eine Klammer und eine Vorrichtung zum Transport und vorzugsweise auch elektrischen Kontaktieren eines Behandlungsgutes, wie zum Beispiel Leiterplatten oder Leiterfolien, in einer Elektrolyseanlage. Bei Elektrolyseanlagen zum elektrolytischen bzw. galvanischen Behandeln eines Behandlungsgutes in Form von Leiterplatten oder Leiterfolien ist es üblich, das Behandlungsgut während der Behandlung durch ein Bad mit der Elektrolyselösung zu führen, wobei der Transport üblicherweise in einer horizontalen Transportebene erfolgt. Während der Elektrolysebehandlung ist es erforderlich, das Behandlungsgut elektrisch zu kontaktieren, um einen Strom von einer in der Elektrolyselösung befindlichen Anode über die Elektrolyselösung zu dem als Kathode dienenden Behandlungsgut führen zu können und auf diese Weise eine elektrolytische Abscheidung von Material, beispielsweise Kupfer, auf dem Behandlungsgut oder einen Abtrag von Material, z. B. durch Ätzen, bewirken zu können. Der Transport des Behandlungsgutes durch die Elektrolyselösung und die gleichzeitige elektrische Kontaktierung, wobei elektrische Ströme von bis zu 2000 A/m². in Spitzen bis zu 10.000 A/m², bezogen auf die Zuschnittfläche der Leiterplatte übertragen werden müssen, stellt ein nicht unerhebliches technisches Problem dar.

Aus der EP 0 561 184 A1 ist eine Galvanisiereinrichtung mit einem Transportsystem für Leiterplatten bekannt, bei welchem die Leiterplatten von zangenartigen Greifern kontaktiert werden. Die Greifer fassen von oben und unten auf die Leiterplatten, wobei die Leiterplatten an ihrem in der Transportrichtung vorderen Ende gegriffen werden. Die aus dieser Veröffentlichung bekannten Verfahren und Vorrichtungen entsprechen den Merkmalen im Oberbegriff der unabhängigen Patentansprüche 1, 8 und 19.

Die EP 0 254 962 beschreibt eine Galvanisiereinrichtung für Leiterplatten, bei welcher die Leiterplatten auf einer horizontalen Durchlaufbahn durch eine Behandlungszelle geführt werden. Hierfür sind zangenförmige Kontaktklemmen vorgesehen.

Ähnliche Transportsysteme sind aus der US 5,755,935 und der WO 99/10568 bekannt, wobei in diesen Fällen lediglich eine Klemmfläche in Richtung der Transportebene beweglich ausgestaltet ist.

Aus der DE 36 24 481 ist eine Vorrichtung bekannt, bei welcher der Transport des Behandlungsgutes und das elektrische Kontaktieren durch Klammern erfolgt, welche in einer Reihe nebeneinander auf einem endlos umlaufenden Antriebsriemen angeordnet sind. Die Klammern greifen das Behandlungsgut am Anfang des Transportweges, indem sie aus einem offenen Zustand in einen geschlossenen Zustand gebracht werden, und stellen auf diese Weise gleichzeitig den erforderlichen elektrischen Kontakt zu dem Behandlungsgut her. Am Ende des Transportweges werden die Klammern jeweils aus dem geschlossenen in den geöffneten Zustand gebracht, um das Behandlungsgut wieder freizugeben. Dabei wird üblicherweise das Behandlungsgut auf dem Transportweg gleichzeitig von mehreren nebeneinander angeordneten Klammern gegriffen und kontaktiert.

Bei dieser bekannten Vorrichtung zum Transport eines flachen Behandlungsgutes sind die Klammern derart ausgestaltet, dass eine erste Klammerhälfte mit einer ersten Klemmfläche unterhalb der Transportebene bezüglich der Transportebene unbeweglich angeordnet ist. Eine zweite Klammerhälfte, welche eine zweite Klemmfläche aufweist, ist oberhalb der Transportebene angeordnet und bezüglich der Transportebene beweglich. Die Bewegung der zweiten Klammerhälfte in Richtung der Transportebene, um die Klammer in den geschlossenen Zustand zu bringen, erfolgt durch eine Federkraft. Die umgekehrte Bewegung, um die Klammer aus dem geschlossenen in den geöffneten Zustand zu bringen, erfolgt gegen die Federkraft, indem ein fest mit der zweiten Klammerhälfte verbundenes Teil über eine entlang des Transportweges fest angeordnete Rampe geführt wird, so dass insgesamt eine Bewegung der zweiten Klammerhälfte und der zweiten Klemmfläche nach oben bewirkt wird.

Bei dieser bekannten Anordnung bestehen jedoch Probleme bezüglich des Einführens des Behandlungsgutes zwischen die untere Klemmfläche und die obere Klemmfläche. Da die untere Klemmfläche bezüglich der Transportebene fest angeordnet ist, schließt sie bündig mit der Transportebene ab. Um zu vermeiden, dass das Behandlungsgut beim Einführen zwischen die untere Klemmfläche und die obere Klemmfläche an eine Kante der unteren Klemmfläche anstößt oder durch sie verkratzt wird, ist es erforderlich, das Behandlungsgut aus der Transportebene hinaus anzuheben und dann zwischen die untere Klemmfläche und die obere Klemmfläche einzuführen. Dies kann beispielsweise mittels einer im Einführungsbereich angeordneten Rampe geschehen. Diese Vorgehensweise bereitet jedoch insbesondere bei sehr dünnen Leiterplatten und Leiterfolien Probleme, da das Behandlungsgut zum Zeitpunkt der Einklemmung sich nicht in der Transportebene befindet und es dadurch zu einer Dehnung, Stauchung oder sonstigen Verzerrung des Behandlungsgutes kommt. Dieses Problem wird darüber hinaus noch durch Strömungseinflüsse in der Elektrolyselösung verstärkt, durch welche vor allem dünnes Behandlungsgut verformt und aus der vorgesehenen Transportebene ausgelenkt wird, so dass die Auslenkung durch die Rampe entsprechend vergrößert werden muss, um ein sicheres Einführen des Behandlungsgutes zwischen die Klemmflächen zu ermöglichen.

Aufgrund der nachfolgenden elektrolytischen Behandlung oder der Abscheidung von zusätzlichem Material auf dem Behandlungsgut sind Verformungen allgemein nicht mehr reversibel und es kommt zu nicht akzeptablen Passungenauigkeiten bei nachfolgenden Verarbeitungsschritten und damit zu Ausschuss. Ferner kann es im Ausgangsbereich der Vorrichtung, d. h. beim Öffnen der Klammer und anschließenden Weitertransport auf der Seite der bezüglich der Transportebene unbeweglich angeordneten Klammerhälfte, d. h. auf der Unterseite des Behandlungsgutes zu Kratzern kommen, was ebenfalls zu einem erhöhten Ausschuss führt.

Die WO 99/10568 beschreibt den Schutz von Klammern mittels einer Kunststoffabschirmung, um die Abscheidung von Material auf den Klammern zu reduzieren.

Angesichts der oben beschriebenen Probleme besteht die Aufgabe der vorliegenden Erfindung darin, eine Klammer bzw. Vorrichtung zum Transport eines Behandlungsgutes bereitzustellen, welche eine Bewegung des Behandlungsgutes aus der Transportebene hinaus vermeidet und in zuverlässiger Weise gewährleistet, dass das Behandlungsgut während der elektrolytischen Behandlung und des Transports durch die Elektrolyselösung nicht gestaucht, gedehnt oder anderweitig verzerrt wird.

Erfindungsgemäß wird diese Aufgabe gelöst durch ein Verfahren gemäß Anspruch 1, eine Klammer gemäß Anspruch 8 sowie durch eine Vorrichtung gemäß Anspruch 19. Die abhängigen Ansprüche definieren bevorzugte und vorteilhafte Ausführungsformen der Erfindung.

Das erfindungsgemäße Verfahren zum Transport eines Behandlungsgutes sieht vor, dass zum Transport eines Behandlungsgutes entlang eines Transportweges und in einer definierten Transportebene das Behandlungsgut am Anfang des Transportweges durch Einklemmung zwischen eine erste Klemmfläche und eine zweite Klemmfläche, welche vorzugsweise an einer Klammer ausgebildet sind, gegriffen wird, woraufhin die Klemmflächen entlang des Transportweges bewegt werden, um das Behandlungsgut zu transportieren, und anschließend am Ende des Transportweges die Einklemmung gelöst wird, um das Behandlungsgut wieder freizugeben.

Dies ermöglicht, dass die erste Klemmfläche nach dem Greifen des Behandlungsgutes in der Transportebene liegt und bis zum Freigeben des Behandlungsgutes in der Transportebene verbleibt und sich dann von dem Behandlungsgut weg bewegt. Die zweite Klemmfläche kann nach dem Greifen des Behandlungsgutes die entsprechende Seite des Behandlungsgutes unabhängig von der Dicke des Behandlungsgutes mit Kraft kontaktieren, um sich dann bei Freigabe des Behandlungsgutes von diesem weg zu bewegen. Da sowohl die erste als auch die zweite Klemmfläche zum Greifen des Behandlungsgutes auf die Transportebene zu bewegt werden und zum Freigeben des Behandlungsgutes von der Transportebene weg bewegt werden, wird das Behandlungsgut nicht aus der Transportebene heraus bewegt.

Um ein problemloses Einführen des Behandlungsgutes zwischen die Klemmflächen und Entnehmen oder Ausführen von den Klemmflächen zu gewährleisten, ist insbesondere vorgesehen, dass sowohl die erste Klemmfläche als auch die zweite Klemmfläche bezüglich der Transportebene bewegt werden, um das Behandlungsgut zu greifen bzw. wieder freizugeben.

Vorzugsweise wird das Behandlungsgut auch über mindestens eine der Klemmflächen elektrisch kontaktiert, wobei ein über die Klemmfläche übertragener Strom vorzugsweise mindestens 650 A/m bezogen auf die Plattenlänge beträgt.

Die Flächenpressung, mit welcher die Klemmflächen auf das Behandlungsgut gedrückt werden, d. h. die auf das Behandlungsgut ausgeübte Kraft bezogen auf die Klemmfläche, beträgt vorzugsweise 0,2 N/mm² bis 3,5 N/mm², so dass eine ausreichend niederohmige elektrische Kontaktierung ermöglicht wird.

Die erfindungsgemäße Vorrichtung zum Transport eines Behandlungsgutes in einer Elektrolyseanlage ist derart ausgestaltet, dass der Transport des Behandlungsgutes entlang eines Transportweges in einer definierten Transportebene erfolgt, wobei die Vorrichtung eine Vielzahl von Klammern umfasst, welche voneinander beabstandet entlang des Transportweges beweglich angeordnet sind. Die Bewegung der Klammern entlang des Transportweges wird durch ein Antriebsmittel hervorgerufen, welches vorzugsweise als ein umlaufendes Antriebsmittel in Form eines Antriebsriemens oder einer Antriebskette ausgebildet ist.

Die Vorrichtung umfasst Betätigungsmittel, welche derart ausgestaltet sind, dass die Klammern jeweils am Anfang des Transportweges in einen geschlossenen Zustand gebracht werden, um das Behandlungsgut zu greifen und vorzugsweise auch während der elektrolytischen Behandlung elektrisch zu kontaktieren, und dass die Klammern jeweils am Ende des Transportweges in einen offenen Zustand gebracht werden, um das Behandlungsgut wieder freizugeben. Zu diesem Zweck umfassen die Klammern jeweils eine erste Klemmfläche, welche auf einer Seite der Transportebene angeordnet ist, und eine zweite Klemmfläche, welche auf der gegenüberliegenden Seite der Transportebene angeordnet ist. Um zu vermeiden, dass das Behandlungsgut beim Einführen zwischen die erste Klemmfläche und die zweite Klemmfläche an die Klammer anstößt bzw. daran hängen bleibt, ist erfindungsgemäß vorgesehen, dass sowohl die erste Klemmfläche als auch die zweite Klemmfläche bezüglich der Transportebene beweglich ist, um die Klammer zum Greifen des Behandlungsgutes in den geschlossenen Zustand zu bringen bzw. die Klammer zum Freigeben des Behandlungsgutes in den offenen Zustand zu bringen. Dies bedeutet, dass beim Schließen der Klammer die erste Klemmfläche von einer Seite an das Behandlungsgut herangeführt wird, während die zweite Klemmfläche von der anderen Seite an das Behandlungsgut herangeführt wird. Somit befindet sich keine der beiden Klemmflächen in der Nähe der Transportebene, wenn das Behandlungsgut zwischen die beiden Klemmflächen eingeführt wird, so dass es nicht erforderlich ist, das Behandlungsgut aus der Transportebene hinaus zu bewegen, um bei der Einführung zwischen die Klemmflächen ein Anstoßen an Seitenflächen der Klammer zu vermeiden. Dies hat den Vorteil, dass das Behandlungsgut zum Zeitpunkt des Schließens der Klammer stets vollständig in der Transportebene liegt und es dadurch nicht zu einer Stauchung, Dehnung oder sonstigen Verzerrung des dünnen, biegsamen Behandlungsgutes kommt. Dieser Vorteil kommt besonders deutlich zum Tragen, wenn das Behandlungsgut nacheinander von mehreren der Klammern mit geringem Abstand gegriffen wird.

Um Verformungen des Behandlungsgutes weiter zu verringern, ist es vorteilhaft, wenn nach dem Greifen des Behandlungsgutes die Klemmflächen ihre Position bezüglich der Transportebene nicht ändern und die Klemmflächen benachbarter Klammern ihre Position relativ zueinander nicht ändern. Die erfindungsgemäße Vorrichtung bzw. die Klammer sind daher, wie nachfolgend näher erläutert, so ausgeführt, dass die in die Klammer eingeleiteten Kräfte zu möglichst geringen Auslenkungen führen.

Die erfindungsgemäße Klammer ist entsprechend den oben ausgeführten Merkmalen ausgestaltet. Zu diesem Zweck umfasst sie vorzugsweise ein erstes Klammerteil mit der ersten Klemmfläche, ein zweites Klammerteil mit der zweiten Klemmfläche und ein Basisteil mit einem Anbringungsbereich zur Anbringung der Klammer an dem Antriebsmittel, wobei sowohl das erste Klammerteil als auch das zweite Klammerteil beweglich an dem Basisteil angebracht sind. Vorzugsweise handelt es sich bei der beweglichen Anbringung um eine verschiebbare Anbringung. Es ist jedoch auch eine schwenkbare Anbringung möglich.

Die Klammern sind vorzugsweise derart ausgestaltet, dass sie durch eine Federkraft in dem geschlossenen Zustand gehalten werden und das Öffnen der Klammer mittels des Betätigungsmechanismus gegen die Federkraft erfolgt. Auf diese Weise ist gewährleistet, dass die durch die Klammer auf das Behandlungsgut ausgeübte Kraft durch die Federkraft bestimmt und auf diese Weise einfach und präzise an die Erfordernisse angepasst werden kann. Die Flächenpressung, mit welcher die Klemmflächen gegen das Behandlungsgut gedrückt werden, liegt vorzugsweise im Bereich von etwa 0,2 N/mm² bis 3,5 N/mm². Weiterhin wird die Ausgestaltung der Klammer vereinfacht, da nur für eine Bewegungsrichtung der Klemmflächen eine aktive Betätigung durch die Betätigungsmittel erfolgen muss.

Als Betätigungsmittel, um das Öffnen bzw. das Schließen der Klammer zu veranlassen, können verschiedenartige Konstruktionen vorgesehen sein. Diese können beispielsweise einen hydraulischen Antrieb, einen pneumatischen Antrieb, einen Elektroantrieb oder einen Magnetantrieb umfassen.

Da wie eingangs beschrieben die Transportebene über den gesamten Transportweg gleich ist, ist es vorteilhaft, die Betätigungsmittel so zu steuern, dass auch unterschiedlich dickes Behandlungsgut ohne Beschädigung gegriffen werden kann. Dies setzt voraus, dass auch bei einem bauartbedingten maximal zulässigen Dickenunterschied die eine Klemmfläche der anderen nicht unzulässig vorauseilt, z. B. weil sie aufgrund der Dicke des Behandlungsgutes einen kürzeren Weg zurücklegen muss, bis sie das Behandlungsgut berührt, so dass z. B. die obere Klemmfläche vor der unteren auf das Behandlungsgut drückt. Dies würde dazu führen, dass die eine Klemmfläche das Behandlungsgut aus der Transportebene herausdrückt, bevor die andere Klemmfläche am Behandlungsgut anliegt, wobei erst das weitere Zusammenführen der Klemmflächen das Behandlungsgut in die Transportebene zurückführt. In diesem Zusammenhang ist es vorteilhaft, die Bewegung der Klemmflächen abhängig von der Dicke des Behandlungsgutes zu steuern. So kann beispielsweise eine zeitlich vorgezogene Bewegung der unteren Klemmfläche veranlasst werden, oder die Bewegungsgeschwindigkeit der Klemmflächen kann angepasst werden, so dass sich die untere Klemmfläche bei größerer Dicke des Behandlungsgutes schneller bewegt als die obere Klemmfläche. Die Erfassung der Dicke des Behandlungsgutes kann wenn nötig über eine entsprechend ausgestaltete Sensorik erfolgen.

Vorzugsweise sind die Betätigungsmittel derart ausgestaltet, dass sie die Bewegung der Klammern entlang des Transportweges mechanisch mit der Bewegung der ersten Klemmfläche und der zweiten Klemmfläche bezüglich der Transportebene koppeln. Eine solche mechanische Ausgestaltung der Betätigungsmittel bietet den Vorteil, mit einem geringen Aufwand realisierbar zu sein und darüber hinaus zuverlässig und robust gegenüber äußeren Störeinflüssen zu sein. Letzteres ist insbesondere in dem Umfeld einer Elektrolyseanlage von Bedeutung, bei welcher sowohl Chemikalien als auch hohe elektrische Ströme zum Einsatz kommen. Eine einfache Ausgestaltung der mechanischen Betätigungsmittel könnte beispielsweise darin bestehen, für die erste Klemmfläche eine erste Klammerhälfte bereitzustellen und für die zweite Klemmfläche eine zweite Klammerhälfte bereitzustellen, wobei die beiden Klammerhälften derart angetrieben sind, dass ihre Bewegung entlang des Transportweges mit einer Bewegungskomponente senkrecht zu der Transportebene erfolgt, so dass die Klemmflächen sich während der Bewegung der beiden Klammerhälften entlang des Transportweges zunächst auf die Transportebene zu und dann von der Transportebene weg bewegen.

Eine weitere Möglichkeit besteht darin, entlang des Transportweges ein fest angeordnetes keilförmiges Element vorzusehen, welches mit Vorsprüngen an der ersten Klammerhälfte und der zweiten Klammerhälfte in Kontakt kommt, so dass die Klammerhälften relativ zur Transportebene bewegt werden. Beispielsweise können die Klammerhälften durch das keilförmige Element gegen eine Federkraft auseinandergedrückt werden. Das keilförmige Element ist vorzugsweise derart angeordnet, dass sich die eingeleiteten Kräfte zur Betätigung der ersten und zweiten Klammerhälfte im Wesentlichen ausgleichen.

Vorzugsweise umfassen die mechanischen Betätigungsmittel ein jeweils an den Klammern angeordnetes Mitnehmerrad und an einer vorbestimmten Position entlang des Transportweges fest angeordnete Eingriffmittel, wobei das Mitnehmerrad und die Eingriffmittel derart angeordnet sind, dass das Mitnehmerrad mit den Eingriffmitteln in Eingriff kommt, wenn die jeweilige Klammer die vorbestimmte Position durchläuft, so dass eine Rotation des Mitnehmerrads bewirkt wird. In den Klammern sind dann vorzugsweise jeweils Umsetzungsmittel zur Umsetzung der Rotationsbewegung des Mitnehmerrads in die Bewegung der Klemmflächen bezüglich der Transportebene vorgesehen. Die Verwendung des Mitnehmerrads ermöglicht eine verschleißarme Übertragung von Kraft aus der Bewegung der Klammern entlang des Transportweges in die Bewegung der Klemmflächen bezüglich der Transportebene. Das Mitnehmerrad ist vorzugsweise im Bereich von Führungsmitteln zum Führen der Bewegung der Klammer entlang des Transportweges angeordnet, so dass über das Mitnehmerrad auf die Klammer ausgeübte Hebelkräfte gering sind.

Die Umsetzungsmittel zur Umsetzung der Rotationsbewegung des Mitnehmerrads in die Bewegung der Klemmflächen bezüglich der Transportebene umfassen vorzugsweise eine in Rotation mit dem Mitnehmerrad gekoppelte Drehscheibe, welche eine äußere Umfangsfläche aufweist, deren radialer Abstand zu der Drehachse der Drehscheibe entlang der Umfangsrichtung variiert, d.h. als Kurvenscheibe ausgestaltet ist, wobei ein mit der ersten Klemmfläche bewegliches erstes Führungsteil und/oder ein mit der zweiten Klemmfläche bewegliches zweites Führungsteil durch eine Federkraft in Kontakt mit einem Bereich der äußeren Umfangsfläche der Drehscheibe gehalten sind. Die Federkraft kann dabei gleichzeitig die zum Bewegen der Klemmflächen in den geschlossenen Zustand erforderliche Kraft bereitstellen, wie zuvor beschrieben. Bei dieser Ausgestaltung der Umsetzungsmittel ist es einerseits möglich, dass das erste und das zweite Führungsteil mit derselben Umfangsfläche der Drehscheibe in Kontakt stehen. Andererseits können für jedes der Führungsteile separate Umfangsflächen der Drehscheibe, oder sogar zwei separate Drehscheiben, welche jeweils in Rotation mit dem Mitnehmerrad gekoppelt sind, vorgesehen sein. In jedem Fall wird eine kompakte Konstruktion bereitgestellt, welche die Umsetzung der Rotationsbewegung des Mitnehmerrads in die Bewegung der Klemmflächen bezüglich der Transportebene umsetzt. Jede Klemmfläche kann somit mit einem individuellen Bewegungsablauf beim Greifen und Freigeben des Behandlungsgutes sowie mit einem definierten Beharrungszustand zwischen den beiden Vorgängen versehen werden. Vorzugsweise sind die Drehscheibe und das Mitnehmerrad in dem bezüglich der Transportebene nicht beweglichen Basisteil der Klammer angeordnet, an welchem die mit der ersten Klemmfläche und der zweiten Klemmfläche beweglichen ersten und zweiten Klammerteile, welche mit den Führungsteilen fest verbunden sind, verschiebbar angebracht sind.

Weiterhin ist es bevorzugt, für mindestens eine der Klemmflächen einen Anschlag vorzusehen, welcher die Bewegung der Klemmfläche derart begrenzt, dass sie nicht über die Transportebene hinaus beweglich ist. Hierdurch kann verhindert werden, dass durch ungleichmäßig ausgeübte Kräfte der ersten und der zweiten Klemmfläche das Behandlungsgut aus der Transportebene herausgedrückt wird. Weiterhin ist es in diesem Fall auch nicht erforderlich, dass die Bewegung der ersten Klemmfläche und der zweiten Klemmfläche zeitgleich erfolgt. Der Einklemmvorgang kann mit einer hohen Zuverlässigkeit bewerkstelligt werden, indem zunächst eine der Klemmflächen bis an ihren Anschlag und somit bis an die Transportebene herangeführt wird, woraufhin die andere Klemmfläche von der anderen Seite an das Behandlungsgut herangeführt wird, um dieses einzuklemmen.

Das Antriebsmittel ist vorzugsweise als endlos umlaufendes Antriebsmittel, beispielsweise in Form eines geschlossenen Antriebsriemens oder einer geschlossenen Antriebskette ausgebildet. Die Klammern sind vorzugsweise gleichmäßig beabstandet an dem umlaufenden Antriebsmittel angebracht. Um zu verhindern, dass sich der relative Abstand benachbarter Klammern ändert, während das Behandlungsgut durch diese Klammern gegriffen ist, ist es bevorzugt, das Antriebsmittel derart auszugestalten, dass es eine Verschiebung der Klammern relativ zueinander verhindert. Diesbezüglich ist beispielsweise die Ausgestaltung des umlaufenden Antriebsmittels als Antriebskette von Vorteil, da in diesem Fall aufgrund des starren Charakters der Kettenglieder nur eine geringe Bewegung der an der Antriebskette befestigten Klammern relativ zueinander möglich ist. Weiterhin ist es auch möglich, einen bandförmigen Antriebsriemen aus einem flexiblen Material zu verwenden, wobei bevorzugt ein Material mit einer hohen Widerstandsfähigkeit gegenüber Dehnung und Stauchung zum Einsatz kommt. Vorzugsweise ist in dem riemenförmigen Antriebsmittel eine eingebettete Armierung vorgesehen, um seine Steifigkeit zu erhöhen und eine präzisere Führung der Klammern zu ermöglichen. Bei der Auswahl der Werkstoffe für das Antriebsmittel ist es vorteilhaft, Materialien mit einer geringen temperaturabhängigen Dehnung oder Schrumpfung auszuwählen. Weiterhin können ein Spannungsmechanismus oder andere Spannmittel vorgesehen sein, um eine Relativbewegung der Klammern zu minimieren. Die Spannmittel können mit einer Spannkraftüberwachung für das Antriebsmittel ausgestaltet sein. Auf diese Weise können auch Störungen im Umlauf der Antriebsmittel erfasst werden.

Wenn das Antriebsmittel bandförmig ausgestaltet ist, steht eine große Anbringungsfläche für die Klammern zur Verfügung, so dass eine Verkippung der Klammern entlang der Transportrichtung verhindert wird. Dies ist insbesondere dann von Vorteil, wenn die Anbringung der Klammern an dem Antriebsmittel außerhalb der Transportebene erfolgt, so dass zwischen den Klemmflächen der Klammer und dem Anbringungsbereich an dem Antriebsmittel ein Hebelarm ausgebildet ist. Das Anordnen des Antriebsmittels außerhalb der Transportebene bietet dabei den Vorteil, dass das Antriebsmittel bei einer horizontal verlaufenden Transportebene oberhalb des Flüssigkeitsspiegels der Elektrolyselösung angeordnet sein kann, wodurch für das Antriebsmittel und die damit verbundenen Komponenten weniger hohe Anforderungen bezüglich der Beständigkeit gegenüber Chemikalien bestehen.

Vorzugsweise sind an dem Antriebsmittel in vorbestimmten Abständen Anbringungsteile zur Anbringung der Klammern befestigt, wobei sich die Anbringungsteile vorzugsweise über die gesamte Breite des Antriebsmittels erstrecken, um eine hohe Widerstandsfähigkeit bezüglich der Hebelkräfte aufzuweisen. Besonders bevorzugt ist es in diesem Zusammenhang, zwischen den Klammern und den Anbringungsteilen eine Schnelllöseverbindung vorzusehen. Hierdurch können die Klammern zu Wartungszwecken oder falls das Ersetzen einer Klammer erforderlich sein sollte, auf einfache Weise von dem Antriebsmittel gelöst bzw. daran befestigt werden. Bei der Ausgestaltung des Antriebsmittels als Antriebskette können die Anbringungsteile auch einheitlich mit den Kettengliedern ausgebildet sein.

Um im geschlossenen Zustand der Klammer die relativen Bewegungen der Klemmflächen benachbarter Klammern weiter einzuschränken, ist es bevorzugt, dass die Vorrichtung im Anbringungsbereich der Klammern an dem umlaufenden Antriebsmittel mindestens eine sich parallel zum Transportweg erstreckende Führungsnut oder Führungsschiene umfasst, wobei die Anbringungsteile und/oder die Klammern jeweils mindestens ein Führungselement aufweisen, welches dazu ausgestaltet ist, während der Bewegung der Klammer entlang des Transportweges in der Führungsnut aufgenommen zu werden. Durch die Führungsnut werden Bewegungen der Klemmflächen sowohl in der Richtung senkrecht zu dem Transportweg als auch parallel zu dem Transportweg eingeschränkt und auf diese Weise Verformungen des Behandlungsgutes vermieden. In diesem Zusammenhang ist es besonders vorteilhaft, wenn an beiden Seiten des umlaufenden Antriebsmittels jeweils eine Führungsnut vorgesehen ist, so dass ein Paar von Führungsnuten bereitgestellt ist, welche vorzugsweise entgegengesetzt gerichtete Aufnahmen für ein entsprechendes Führungselement an den Anbringungsteilen und/oder Klammern aufweisen. Die Aufnahmen der Führungsnuten können einander zugewandt sein, so dass die Führungsnuten das Anbringungsteil und/oder die Klammer von beiden Seiten umfassen. Auf diese Weise kann die Bewegung der Klammern senkrecht zu der Transportebene in besonders effektiver Weise eingeschränkt werden. Weiterhin werden durch die beidseitige Führung Verkippungen der Klammer um ihren Anbringungspunkt unterdrückt.

Insbesondere in dem Fall, dass das umlaufende Antriebsmittel sich außerhalb der Transportebene befindet, beispielsweise oberhalb der Transportebene im Fall einer horizontalen Ausrichtung der Transportebene, ist es bevorzugt, dass auch eine Führungsnut vorgesehen ist, welche sich im Wesentlichen in der Transportebene und entlang des Transportweges erstreckt, wobei dann an den Klammern jeweils ein Führungselement vorgesehen ist, welches dazu ausgestaltet ist, während der Bewegung der Klammer entlang des Transportweges in dieser Führungsnut aufgenommen zu werden. Da diese Führungsnut in der Nähe der Klemmflächen an den Klammern angreift, kann Hebelkräften, welche im Bereich der Klemmflächen auf die Klammern einwirken, besonders effektiv entgegengewirkt werden.

Bei den zuvor beschriebenen Führungsnuten und Führungselementen der Anbringungsteile und/oder Klammern ist es besonders bevorzugt, wenn die Führungselemente eine längliche Form aufweisen, d.h. sich über eine bestimmte Länge entlang des Transportweges erstrecken, wenn sie in der Führungsnut aufgenommen sind. Hierdurch wird eine noch effektivere Unterdrückung von Verkippungen der Klammern bezüglich ihres Anbringungspunktes an dem umlaufenden Antriebsmittel um eine sich senkrecht zu dem Transportweg erstreckende Achse erreicht.

Besonders bevorzugt ist es, wenn die Führungselemente sich über eine Länge erstrecken, welche derart bemessen ist, dass die Führungselemente benachbarter Klammern im Bereich des Transportweges im Wesentlichen aneinander angrenzen. Auf diese Weise wird zum einen erreicht, dass die Führungswirkung der Führungselemente optimal ausgenutzt wird. Darüber hinaus wird erreicht, dass unerwünschte Bewegungen oder Verkippungen von benachbarten Anbringungsteilen und/oder Klammern zusätzlich durch die jeweils benachbarten Führungselemente eingeschränkt ist. Weiterhin wird einer Stauchung des Antriebsmittels im Bereich der sich auf dem Transportweg befindlichen Klammern entgegengewirkt.

Weiterhin ist es bevorzugt, dass die Klammern zur Zuführung des elektrischen Stroms für die elektrolytische Behandlung jeweils Kontaktmittel, z. B. in Form eines Schleifkontakts oder Rollenkontakts aufweisen, welche dazu ausgestaltet ist, in gleitenden bzw. rollenden Kontakt mit einer fest angeordneten Stromschiene zu kommen. Der auf diese Weise bereitgestellte Stromkontakt ist vorzugsweise unabhängig von der Bewegung der Klemmflächen steuerbar, so dass das Auftreten eines unkontrollierten Stromflusses oder von Überschlägen bei der Annäherung der Klemmflächen an das Behandlungsgut vermieden werden kann. Insbesondere kann auf diese Weise sichergestellt werden, dass der Stromfluss nur dann aktiviert wird, wenn durch die Klemmflächen bereits ein sicherer Klemmkontakt zu dem Behandlungsgut hergestellt ist.

Insgesamt ermöglicht die vorhergehend beschriebene Erfindung somit insbesondere bei sehr dünnem Behandlungsgut in Form von Leiterfolien eine effektive elektrolytische Behandlung, ohne dass es zu dauerhaften Verformungen oder Beschädigungen des Behandlungsgutes kommt. Weiterhin gewährleistet die erfindungsgemäß vorgesehene beidseitige Bewegung der Klemmflächen bezüglich der Transportebene eine zuverlässige Klemmung, welche unabhängig von der Stärke des Behandlungsgutes ist.

Die vorliegende Erfindung wird nachfolgend anhand eines bevorzugten Ausführungsbeispiels unter Bezugnahme auf die beigefügten Zeichnungen näher erläutert.
Fig. 1 veranschaulicht schematisch die Funktionsweise einer Vorrichtung zum elektrischen Kontaktieren und Transport von Leiterplatten oder Leiterfolien in einer Elektrolyseanlage gemäß einem Ausführungsbeispiel der Erfindung.
Fig. 2A und Fig. 2B veranschaulichen schematisch die Funktionsweise einer Klammer gemäß einem Ausführungsbeispiel der Erfindung, wobei Fig. 2A einen geöffneten Zustand der Klammer veranschaulicht und Fig. 2B einen geschlossenen Zustand der Klammer veranschaulicht.
Fig. 3 zeigt eine Querschnittsansicht der Klammer gemäß dem Ausführungsbeispiel der Erfindung.
Fig. 4A und 4B veranschaulichen die Anbringung der Klammern an einem umlaufenden Antriebsmittel sowie im Anbringungsbereich der Klammern an das Antriebsmittel vorgesehene Führungsmittel gemäß einem Ausführungsbeispiel der Erfindung.
Fig. 5 zeigt eine Querschnittsansicht einer Elektrolyseanlage, welche die in Fig. 1 bis 4 dargestellte Vorrichtung zum elektrischen Kontaktieren und Transport von Leiterplatten oder Leiterfolien umfasst.
Fig. 6 zeigt eine vergrößerte Querschnittsansicht der Anbringung der Klammer in der Elektrolyseanlage.

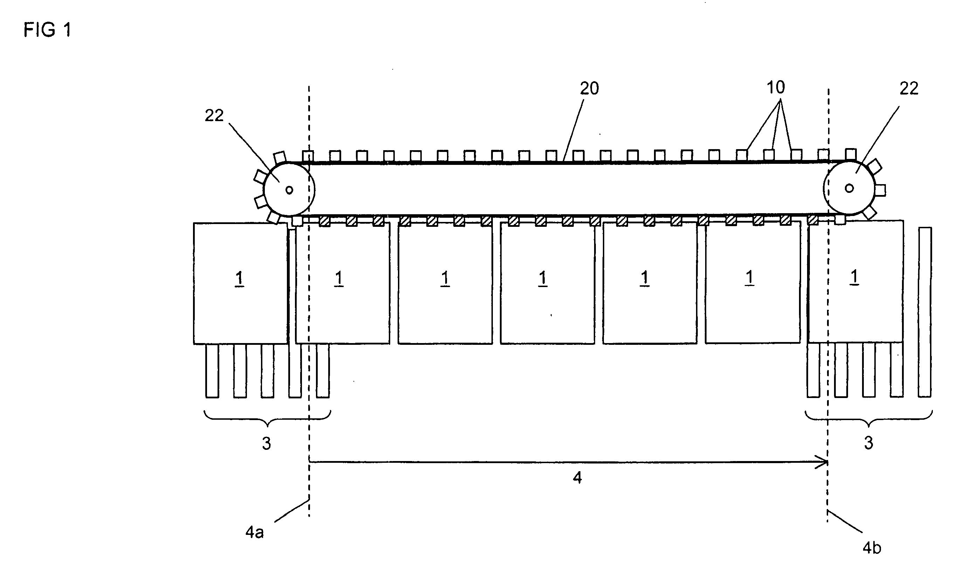

Fig. 1 zeigt schematisch eine Vorrichtung zum elektrischen Kontaktieren und Transport eines flachen Behandlungsgutes 1, z. B. in Form von dünnen Leiterplatten oder Leiterfolien. Das Behandlungsgut 1 wird von der Vorrichtung entlang eines Transportweges 4 geführt, wobei die Transportrichtung in der Abbildung durch die Richtung des dem Transportweg 4 veranschaulichenden Pfeils dargestellt ist. Sowohl am Anfang 4a als auch am Ende 4b des Transportweges 4 sind weitere Transportmittel 3 in Form von Rollen oder Räder angeordnet, welche das Behandlungsgut 1 der Vorrichtung zuführen bzw. aus der Vorrichtung herausführen.

Entlang des Transportweges 4 erfolgt der Transport des Behandlungsgutes 1 durch Klammern 10, welche an einem endlos umlaufenden Antriebsmittel 20 in Form eines Riemens oder einer Kette angebracht sind. Das umlaufende Antriebsmittel 20 ist um vorzugsweise gezahnte Rollen 22 geführt und durch einen nicht dargestellten Motor angetrieben.

Die Klammern 10 sind derart ausgestaltet, dass sie am Anfang des Transportweges 4a aus einem offenen Zustand in einen geschlossenen Zustand gebracht werden, so dass sie das Behandlungsgut 1 greifen. Durch das Greifen des Behandlungsgutes 1 erfolgt gleichzeitig das elektrische Kontaktieren des Behandlungsgutes 1, um während des Transports des Behandlungsgutes 1 über den Transportweg 4 eine elektrolytische Behandlung des Behandlungsgutes 1 durchführen zu können. Durch die elektrolytische Behandlung wird ein leitfähiges Material, beispielsweise Kupfer, auf dem Behandlungsgut 1 abgeschieden. Am Ende 4b des Transportweges 4 werden die Klammern 10 aus dem geschlossenen Zustand zurück in den offenen Zustand gebracht, um das Behandlungsgut 1 wieder freizugeben. In Fig. 1 sind diejenigen Klammern, welche sich auf dem Transportweg 4 und somit in dem geschlossenen Zustand befinden, schraffiert dargestellt.

Wie es aus Fig. 1 ersichtlich ist, wird das Behandlungsgut 1 auf einer Seite des umlaufenden Antriebsmittels 20 entlanggeführt. Auf der anderen Seite des umlaufenden Antriebsmittels 20 befinden sich die Klammern 10 im geöffneten Zustand. Dieser Bereich, in welchem die Klammern 10 von dem Ende 4b des Transportweges 4 zu seinem Anfang 4a zurücklaufen, wird vorzugsweise genutzt, um die Klammern 10 von während der elektrolytischen Behandlung des Behandlungsgutes 1 abgeschiedenem Material zu reinigen.

Die als Rollen oder Räder ausgestalteten weiteren Transportmittel 3 am Anfang 4a und Ende 4b des Transportweges 4 sowie die Klammern 10 gewährleisten einen Transport des Behandlungsgutes 1, welcher innerhalb einer definierten Transportebene 2 erfolgt. Um zu gewährleisten, dass das Behandlungsgut 1 am Anfang 4a und am Ende 4b des Transportweges 4 in derselben Ebene transportiert wird, wie im Bereich der als Rollen ausgestalteten Transportmittel 3 ist ein Überlappbereich zwischen den Transportmitteln 3 und dem Transportweg 4 vorgesehen. Weiterhin sind entlang des Transportweges 4 Gleitführungen und/oder Räder vorgesehen (nicht dargestellt), welche das Behandlungsgut 1 während des Transports entlang des Transportweges 4 unterstützen, so dass es auf seiner gesamten Breite in der Transportebene 2 gehalten wird.

In Fig. 1 ist eine Anordnung dargestellt, bei welcher das Behandlungsgut 1 nur an einem seiner Ränder durch die Klammern 10 gegriffen wird. Selbstverständlich ist es auch möglich, ein weiteres Antriebsmittel 20 mit Klammern 10 vorzusehen, um das Behandlungsgut 1 auch an seiner gegenüberliegenden Seite zu greifen.

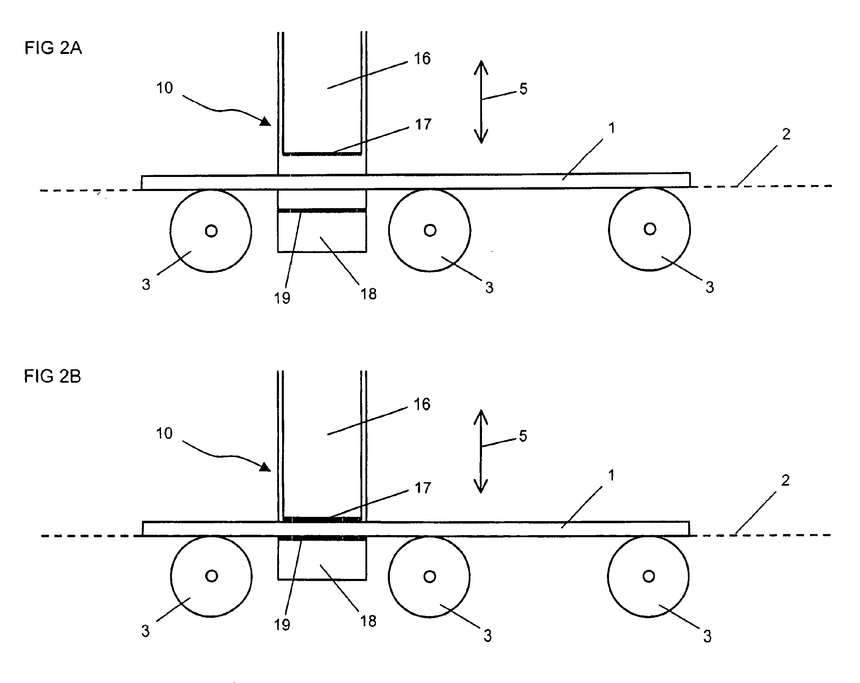

Fig. 2A und 2B veranschaulichen schematisch die Funktionsweise der Klammern 10. Die Darstellung von Fig. 2A entspricht einem offenen Zustand der Klammer 10 und die Darstellung von Fig. 2B entspricht dem geschlossenen Zustand der Klammer 10. Die Transportebene 2 ist in Fig. 2A und 2B als gestrichelte Linie dargestellt. Im Folgenden wird davon ausgegangen, dass die Transportebene 2 sich in einer horizontalen Ebene erstreckt. Es sind jedoch auch andere Ausrichtungen der Transportebene 2 möglich, beispielsweise eine vertikale Ausrichtung. In diesem Fall können, um eine verbesserte Führung des Behandlungsgutes 1 durch die als Rollen ausgestalteten Transportmittel 3 zu gewährleisten, Rollen auf beiden Seiten der Transportebene 2 vorgesehen sein. Bei der horizontalen Ausrichtung der Transportebene 2, von welcher im Folgenden ausgegangen wird, können bei den Transportmitteln 3 Rollen lediglich unterhalb der Transportebene 2 vorgesehen sein, eine beidseitige Anordnung ist jedoch auch möglich und bietet Vorteile beim Entgegenwirken von Strömungseinflüssen.

Wie in Fig. 2A und 2B dargestellt, umfasst die Klammer 10 einen unteren ersten Klammerteil 18 und einen oberen zweiten Klammerteil 16. Der untere Klammerteil 18 umfasst eine untere erste Klemmfläche 19 und der obere Klammerteil 16 umfasst eine obere zweite Klemmfläche 17. Die untere Klemmfläche 19 ist unterhalb der Transportebene 2 angeordnet und die obere Klemmfläche 17 ist oberhalb der Transportebene 2 angeordnet. Sowohl die obere Klemmfläche 17 als auch die untere Klemmfläche 19 sind bezüglich der Transportebene 2 entlang einer veranschaulichten Klemmrichtung 5 beweglich, um die Klammer 10 zu öffnen bzw. zu schließen.

In dem in Fig. 2A dargestellten geöffneten Zustand weisen die Klemmflächen 17, 19 einen vorgegebenen Abstand zu der Transportebene 2 auf, welcher es ermöglicht, das Behandlungsgut 1 zwischen die Klemmflächen 17, 19 einzuführen, ohne dass das Behandlungsgut 1 seitlich an die Klammerteile 16, 18 anstößt. Da sowohl nach oben als auch nach unten ein ausreichender Freiraum besteht, ist es auch nicht erforderlich, das Behandlungsgut 1 aus der Transportebene 2 herauszubewegen, um ein zuverlässiges Einführen des Behandlungsgutes 1 zwischen die Klemmflächen 17, 19 zu gewährleisten. Dies ist auch bei unterschiedlich dickem Behandlungsgut 1 der Fall.

Wie es aus Fig. 2B ersichtlich ist, ist die Klammer 10 derart ausgestaltet, dass sich im geschlossenen Zustand der Klammer 10 die untere Klemmfläche 19 auf Höhe der Transportebene 2 befindet, d.h. an diese angrenzt, während die obere Klemmfläche 17 an die Oberseite des Behandlungsgutes 1 angrenzt, um zusammen mit der unteren Klemmfläche 19 eine Klemmkraft auf das Behandlungsgut 1 auszuüben. Die an die Transportebene 2 angrenzende Position der unteren Klemmfläche 19 wird vorzugsweise über einen Anschlag gewährleistet, welcher in einem festen Abstand bezüglich der Transportebene 2 angeordnet ist und die Bewegung des unteren Klammerteils 18 nach oben begrenzt.

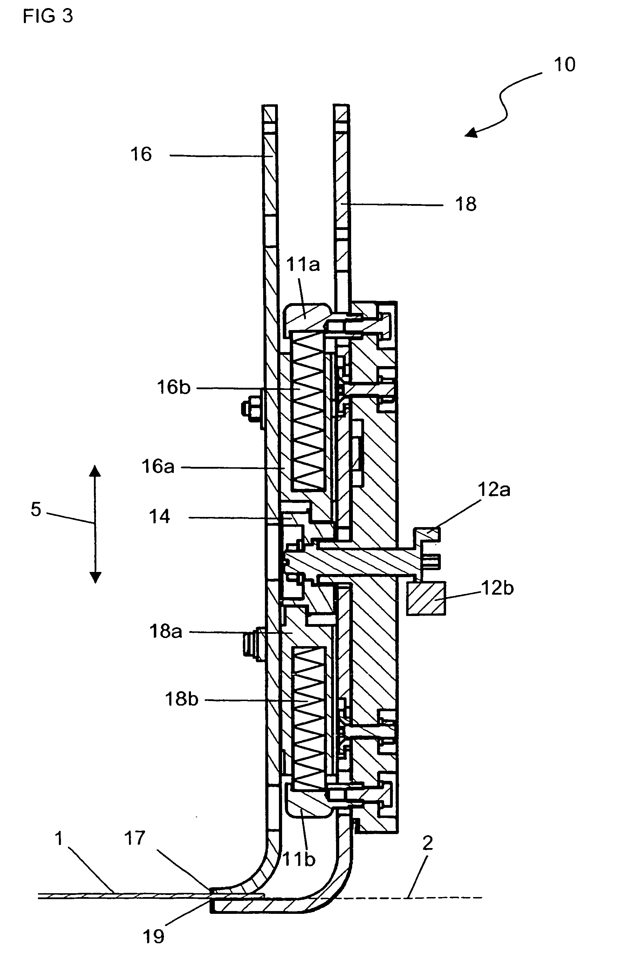

Fig. 3 zeigt eine Schnittansicht der Klammer 10, aus welcher insbesondere auch die zum Öffnen bzw. Schließen der Klammer 10 vorgesehenen Betätigungsmittel erkennbar sind.

Die Klammer 10 umfasst ein Basisteil 11, über welches die Klammer 10 an dem umlaufenden Antriebsmittel 20 befestigt ist. Das Basisteil 11 weist somit einen festen Abstand bezüglich der Transportebene 2 auf. An dem Basisteil 11 sind entlang der Klemmrichtung 5 verschiebbar das obere Klammerteil 16 und das untere Klammerteil 18 angebracht. Das obere Klammerteil 16 und das untere Klammerteil 18 sind als Metallbügel ausgebildet, welche jeweils einen sich entlang der Klemmrichtung 5 erstreckenden vertikalen Abschnitt und einen sich parallel zu der Transportebene 2 erstreckenden horizontalen Abschnitt aufweisen, wobei der horizontale Abschnitt sich jeweils im unteren Bereich der Klammerteile 16, 18 befindet und die obere Klemmfläche 17 und die untere Klemmfläche 19 an dem Ende des horizontalen Abschnitts des Klammerteils 16 bzw. 18 ausgebildet ist. Die horizontalen Abschnitte gewährleisten, dass die Klemmflächen 17, 19 an einander gegenüberliegenden Positionen bezüglich der Transportebene 2 angeordnet sind und durch relatives Verschieben der Klammerteile 16, 18 entlang der Klemmrichtung 5 aufeinander zu bzw. voneinander weg bewegt werden können.

Die Betätigungsmittel umfassen ein an der Klammer 10 angeordnetes Mitnehmerrad 12a, welches derart angeordnet ist, dass es bei der Bewegung der Klammer 10 entlang des Transportweges 4 an bestimmten Positionen mit einer Zahnstange 12b aus Kunststoff oder Metall in Eingriff kommt und durch die Bewegung der Klammer 10 um einen vorbestimmten Betrag bzw. Drehwinkel rotiert wird. Alternativ zu der Zahnstange 12b kann auch ein anderes an einer bestimmten Position des Transportweges 4 fest angeordnetes Eingriffmittel zum Einsatz kommen, im einfachsten Fall ein Vorsprung. Die Verwendung der Zahnstange 12b, welche sich über eine bestimmte Länge entlang des Transportweges 4 erstreckt, bietet jedoch den Vorteil, dass über die Länge der Zahnstange 12b der Drehwinkel, um welchen das Mitnehmerrad 12a rotiert wird, präzise eingestellt werden kann.

Das Mitnehmerrad 12a ist auf einer gemeinsamen Drehachse mit einer Drehscheibe 14 angeordnet, welche entlang der axialen Richtung einen ersten äußeren Umfangsflächenabschnitt und einen zweiten äußeren Umfangsflächenabschnitt aufweist. Der erste äußere Umfangsflächenabschnitt und der zweite äußere Umfangsflächenabschnitt weisen jeweils einen entlang der Umfangsrichtung variierenden radialen Abstand zu der Drehachse der Drehscheibe 14 auf.

Ein mit dem oberen Klammerteil 16 fest verbundenes Führungsteil 16a ist durch eine Feder 16b im gleitenden oder rollenden Kontakt mit einem Bereich des ersten Umfangsflächenabschnitts der Drehscheibe 14 gehalten. Die Feder 16b ist in einer Führungsbohrung des Führungsteils 16a aufgenommen und als Druckfeder zwischen das Führungsteil 16a und ein mit dem Basisteil 11 fest verbundenes Halterungsteil 11a eingefügt. Die Feder 16b verläuft entlang der Klemmrichtung 5, so dass bei einer Rotation der Drehscheibe 14 das Führungsteil 16a und mit diesem das Klammerteil 16 und die Klemmfläche 17 entlang der Klemmrichtung 5 verschoben werden. Die Verschiebung des Führungsteils 16a ist abhängig von dem radialen Abstand des mit dem Führungsteil 16a in Kontakt stehenden Bereichs des ersten äußeren Umfangsflächenabschnitts der Drehscheibe 14 zur Drehachse. Wenn sich dieser radiale Abstand bei einer Rotation der Drehscheibe vergrößert, wird die Feder 16b komprimiert. Wenn sich dieser Abstand bei einer Drehung der Drehscheibe 14 verringert, wird die Feder 16b entlastet.

Eine ähnliche Konstruktion ist für ein mit dem unteren Klammerteil 18 fest verbundenes Führungsteil 18a vorgesehen, welches durch die Federkraft einer Feder 18b in gleitendem Kontakt mit dem zweiten äußeren Umfangsflächenabschnitt der Drehscheibe 14 gehalten ist. Die Feder 18b ist in einer Führungsbohrung des Führungsteils 18a aufgenommen und als Druckfeder zwischen das Führungsteil 18a und ein fest mit dem Basisteil 11 verbundenes unteres Halterungsteil 11 b eingefügt. Wenn sich somit in dem von dem Führungsteil 18a kontaktierten Bereich des zweiten äußeren Umfangsflächenabschnitts der Drehscheibe 14 der radiale Abstand zu der Drehachse aufgrund einer Rotation der Drehscheibe 14 erhöht, wird die Feder 18b komprimiert. Umgekehrt wird, wenn sich dieser Abstand verringert, die Feder 18b entlastet.

In Fig. 3 sind die Führungsteile 16a und 18a an in der Klemmrichtung 5 gegenüberliegenden Seiten der Drehscheibe 14 angeordnet, so dass das Führungsteil 16a die Drehscheibe 14 von oben berührt, während das Führungsteil 18a die Drehscheibe von unten berührt. Die Kontaktierung der äußeren Umfangsfläche der Drehscheibe 14 erfolgt in unterschiedlichen axialen äußeren Umfangsflächenabschnitten der Drehscheibe 14, wobei diese axialen Umfangsflächenabschnitte bezüglich der Variation des radialen Abstands der äußeren Umfangsfläche zu der Drehachse unterschiedlich ausgestaltet sind. Auf diese Weise kann die Bewegung der Führungsteile 16a und 18a und damit der Klammerteile 16 und 18 abhängig von der Drehposition des Mitnehmerrads 12a unabhängig eingestellt werden. Es ist jedoch auch möglich, dass die Drehscheibe 14 nur über einen axialen äußeren Umfangsflächenabschnitt verfügt, mit welchem beide Führungsteile 16a und 18a in Kontakt stehen. In diesem Fall vereinfacht sich der Aufbau der Drehscheibe 14, die Möglichkeiten zur unabhängigen Steuerung der Bewegung der Klammerteile 16 und 18 werden jedoch eingeschränkt.

Wie es aus Fig. 3 und der obigen Beschreibung ersichtlich ist, werden bei der Klammer 10 die obere Klemmfläche 17 und die untere Klemmfläche 19 beim Schließen der Klammer 10 durch die Federkraft der Federn 16b und 18b zusammengedrückt, während beim Öffnen der Klammer 10 die Bewegung der Klammerteile 16 und 18 gegen die Federkraft der Federn 16b und 18b erfolgt, so dass die Federn 16b, 18b komprimiert werden. Die Kraft, mit welcher die Klemmflächen 17, 19 zusammengepresst werden, ist somit durch die Federkraft der Federn 16b, 18b definiert und kann über den Kompressionsweg der Federn 16b, 18b eingestellt werden. Auf diese Weise ermöglicht es die Klammer 10, die bei dem Klemmvorgang auf das Behandlungsgut 1 ausgeübte Kraft entsprechend den Erfordernissen einzustellen. Vorzugsweise beträgt die Kraft, mit welcher die Klemmflächen 17, 19 aufeinander bzw. auf das Behandlungsgut 1 gedrückt werden ungefähr 50 N. Die Flächenpressung beträgt zwischen 0,2 N/mm² und 3,5 N/mm². Es ist möglich, Kräfte von 250 N und mehr über die Klemmflächen 17, 19 auf das Behandlungsgut 1 auszuüben, so dass eine zuverlässige elektrische Kontaktierung des Behandlungsgutes 1, über welche Ströme von 200 A je Klammer und mehr übertragen werden können, gewährleistet ist. Typischerweise liegen die über die Klemmflächen 17, 19 auf das Behandlungsgut 1 übertragenen Ströme im Bereich von 20 A. Der Strom bezogen auf die geklammerte Länge des Behandlungsgutes 10 beträgt typischerweise 350 A/m und kann in Spitzen bis zu 7000 A/m erreichen.

Die Drehscheibe 14 ist vorzugsweise aus einem Metall gefertigt, um eine hohe Festigkeit zu gewährleisten. Die Führungsteile 16a, 18a bestehen zumindest in dem mit der Drehscheibe 14 in Kontakt befindlichen Bereich vorzugsweise aus einem Kunststoffmaterial, so dass eine geringe Reibung, ein geringer Verschleiß und eine elektrische Isolierung gewährleistet ist.

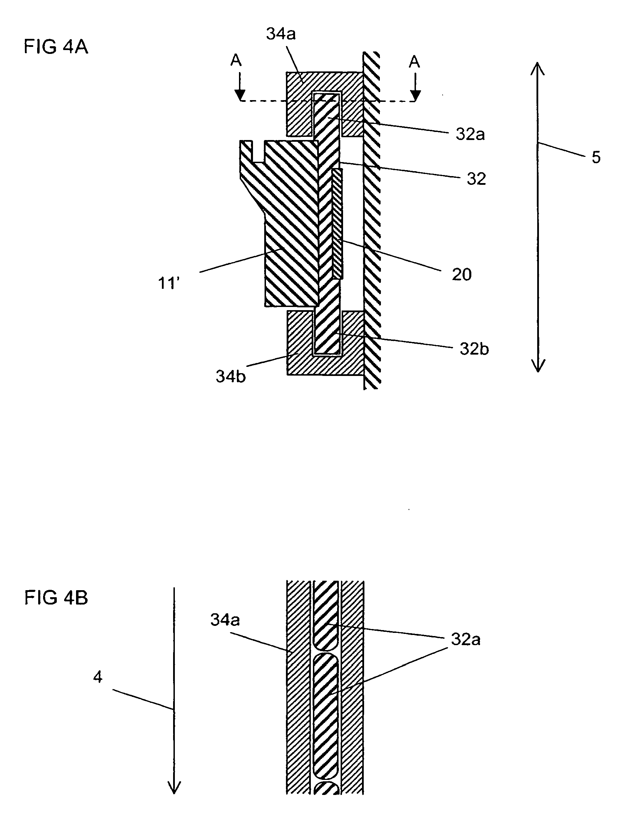

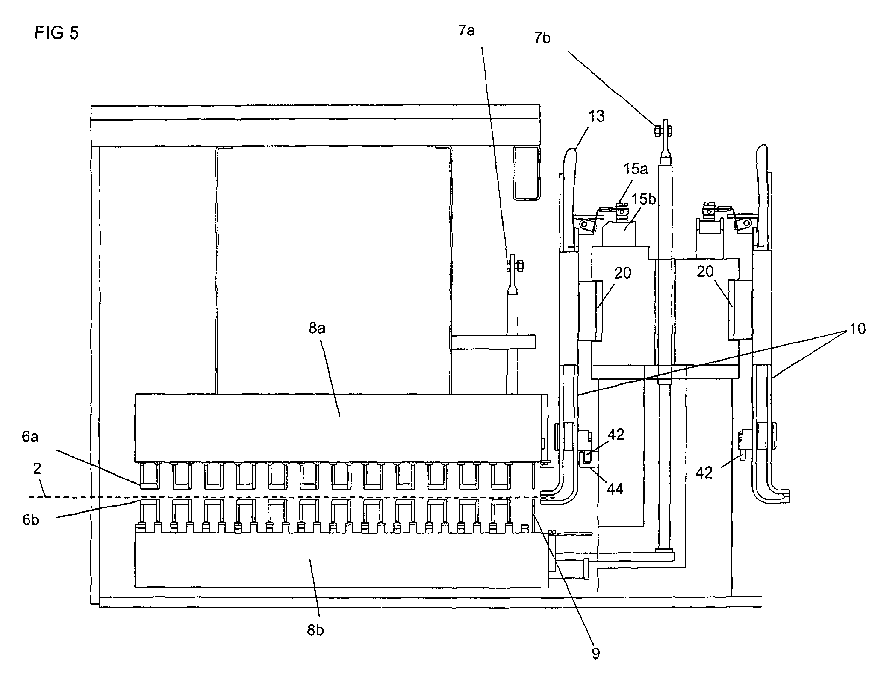

Um zu vermeiden, dass das Behandlungsgut 1 während des Transports mittels der Klammern 10 gedehnt, gestaucht oder in sonstiger Weise verzerrt oder verformt wird, ist es erforderlich, dass während des Schließvorgangs und im geschlossenen Zustand der Klammern 10 eine möglichst geringe relative Bewegung der Klemmbereiche 17, 19 benachbarter Klammern 10 gewährleistet ist. Die Vorrichtung zum elektrischen Kontaktieren und Transport des Behandlungsgutes 1 ist daher derart ausgestaltet, dass Relativbewegungen der im geschlossenen Zustand befindlichen Klammern 10 unterdrückt werden, unabhängig davon, ob diese Klammern 10 gerade das Behandlungsgut 1 greifen oder leer sind. Diesbezüglich ermöglicht zunächst die anhand von Fig. 3 beschriebene Konstruktion zum Öffnen und Schließen der Klammer 10 eine kurze Bauweise der Klammer, so dass Hebelkräfte, welche bezüglich des Anbringungspunktes an dem Antriebsmittel 20 auf die Klammern 10 wirken, gering sind. Weiterhin ist die Anbringung der Klammern 10 an dem Antriebsmittel 20 starr ausgestaltet und es sind Führungsmittel vorgesehen, welche unerwünschte Bewegungen der Klammern 10 auf ein Minimum reduzieren. Die Anbringung der Klammern 10 an dem Antriebsmittel 20 und die Führungsmittel werden nachfolgend anhand von Fig. 4A, 4B und 5 erläutert.

Fig. 4A zeigt eine Querschnittsansicht durch einen Anbringungsbereich der Klammer 10 an dem umlaufenden Antriebsmittel 20. Die Klammer 10 selbst ist aus Gründen der Übersichtlichkeit nicht dargestellt. Dargestellt ist lediglich ein Rückenteil 11' der Klammer, welches im zusammengebauten Zustand fest mit dem Basisteil 11 der Klammer 10 verbunden ist.

Die Befestigung der Klammern 10 an den Anbringungsteilen 32 kann beispielsweise durch Verschraubung erfolgen. Vorzugsweise ist hierfür jedoch eine Schnelllöseverbindung vorgesehen, die z. B. einen Bajonettmechanismus umfasst, welche es ermöglicht, z. B. zu Wartungszwecken, die Klammern 10 mit geringem Aufwand anzubringen und zu entfernen.

Wie es aus Fig. 4A ersichtlich ist, erstreckt sich das umlaufende Antriebsmittel 20 über eine bestimmte Breite senkrecht zu der Transportebene 2, d.h. entlang der Klemmrichtung 5. Das umlaufende Antriebsmittel weist somit die Form eines Bandes oder Riemens bzw. einer breiten Kette auf, und verfügt daher über eine hohe Widerstandsfähigkeit gegenüber Beanspruchungen entlang der Klemmrichtung 5. Im Falle eines Riemens ist vorzugsweise eine Armierung vorgesehen, z. B. in Form von Verstärkungsfasern oder -bändern aus Metall oder einem anderen geeigneten Material, welche in das flexible Material des Riemens eingebracht ist. Auf diese Weise können auf die Klammern hohe Kräfte übertragen werden, wobei gleichzeitig eine gute chemische Beständigkeit, geringe Reibung und geringe Elastizität des Antriebsmittels 20 gewährleistet ist.

An dem umlaufenden Antriebsmittel 20 ist für jede der Klammern 10 ein Anbringungsteil 32 befestigt, welches sich über die gesamte Breite des umlaufenden Antriebsmittels 20 erstreckt. Das Anbringungsteil 32 weist eine Vertiefung zur Aufnahme des umlaufenden Antriebsmittels 20 auf, so dass die Steifigkeit der Verbindung zwischen dem Anbringungsteil 32 und dem Antriebsmittel 20 erhöht wird. Das Anbringungsteil 32 kann beispielsweise durch Schrauben, Kleben oder Ähnliches an dem umlaufenden Antriebsmittel 20 befestigt sein.

Das Anbringungsteil 32 verfügt zu beiden Seiten des umlaufenden Antriebsmittels 20 über Führungselemente 32a, 32b. Das Führungselement 32a erstreckt sich ausgehend von dem Anbringungsteil 32 nach oben, und das Führungselement 32b erstreckt sich ausgehend von dem Anbringungsteil 32 nach unten. Die Führungselemente 32a, 32b sind vorzugsweise einheitlich mit dem Anbringungsteil 32 ausgebildet, können jedoch auch fest mit diesem verbunden sein. Weiterhin ist es auch möglich, die Führungselemente 32a oder 32b als Teil der Klammer 10 vorzusehen, indem sie beispielsweise mit dem Rückenteil 11' verbunden sind oder einheitlich mit diesem ausgebildet sind.

Wie in Fig. 4A dargestellt, verfügt die Vorrichtung über Führungsnuten 34a und 34b, welche sich parallel zu dem Transportweg 4 erstrecken. Eine obere Führungsnut 34a ist oberhalb des Antriebsmittels 20 angeordnet und dazu ausgestaltet, das obere Führungselement 32a aufzunehmen. Zu diesem Zweck weist die obere Führungsnut 34a einen sich nach unten öffnenden im Wesentlichen U-förmigen Querschnitt auf. Eine untere Führungsnut 34b ist unterhalb des umlaufenden Antriebsmittels 20 vorgesehen und dazu ausgestaltet, das untere Führungselement 32b aufzunehmen. Zu diesem Zweck weist die untere Führungsnut 34b einen sich nach oben öffnenden im Wesentlichen U-förmigen Querschnitt auf. Die Führungsnuten 34a und 34b umschließen somit das Anbringungsteil 32 mit den beiden Führungselementen 32a, 32b von beiden Seiten und gewährleisten somit eine enge Führung des Anbringungsteils 32 und der daran angebrachten Klammer 10. Insbesondere werden durch diese Führung unerwünschte Bewegungen der Klammer 10 senkrecht zu der Transportebene 2 sowie auch Verkippungen der Klammer 10 um ihren Anbringungspunkt an dem umlaufenden Antriebsmittel 20 herum unterdrückt.

Fig. 4B zeigt eine Querschnittsansicht der oberen Führungsnut 34a entlang der Linie A-A in Fig. 4A. Wie es aus Fig. 4B ersichtlich ist, weisen die Führungselemente 32a eine längliche Form auf. Auf diese Weise wird die Stabilität der Anbringung der Klammer 10 an dem umlaufenden Antriebsmittel 20 gegenüber Verkippungen und Verdrehungen erhöht. Weiterhin ist aus Fig. 4B erkennbar, dass die Länge der Führungselemente 32a derart bemessen ist, dass benachbarte Führungselemente 32a im Wesentlichen aneinander angrenzen. Die untere Führungsnut 34b sowie die unteren Führungselemente 32b der Anbringungsteile 32 sind in ähnlicher Weise ausgebildet, wie es für die obere Führungsnut 34a und die oberen Führungselemente 32a in Fig. 4B dargestellt ist. Durch diese aneinandergrenzende Anordnung der Führungselemente 32a, 32b wird insgesamt die Steifigkeit des umlaufenden Antriebsmittels 20 erhöht. Darüber hinaus können Stauchungen des umlaufenden Antriebsmittels 20, welche den relativen Abstand benachbarter Klammern 10 verringern würden, effektiv unterdrückt werden.

Das umlaufende Antriebsmittel 20 kann beispielsweise aus einem Kunststoffmaterial ausgebildet sein, während die Anbringungsteile 32 vorzugsweise aus Metall sind. Um gute Gleiteigenschaften der Führungselemente 32a, 32b in den Führungsnuten 34a, 34b zu gewährleisten, sind die Führungsnuten 34a, 34b vorzugsweise aus einem Kunststoffmaterial mit guten Gleiteigenschaften bezüglich des Metalls der Führungselemente 32a, 32b ausgebildet oder in ihren Aufnahmen mit einem solchen Kunststoffmaterial ausgekleidet.

Fig. 5 zeigt eine vereinfachte Querschnittsansicht durch eine Elektrolyseanlage mit der zuvor beschriebenen Vorrichtung zum elektrischen Kontaktieren und Transport des Behandlungsgutes 1.

Die Elektrolyseanlage verfügt über eine in einem Anodenraum obere Anodenanordnung 8a und eine untere Anodenanordnung 8b. Stromzuführungen für die obere Anodenanordnung 8a und die untere Anodenanordnung 8b sind mit 7a bzw. 7b bezeichnet. Zur Führung des Behandlungsgutes 1 entlang der Transportebene 2 sind an der oberen Anodenanordnung 8a und der unteren Anodenanordnung 8b obere Führungselemente 6a bzw. untere Führungselemente 6b ausgebildet, welche sich ausgehend von der Anodenanordnung 8a, 8b in Richtung der Transportebene 2 erstrecken und einen direkten Kontakt des Behandlungsgutes 1 mit den Anodenanordnungen 8a, 8b verhindern. Die Führungselemente 6a, 6b können Räder, Rollen, Leitelemente oder Ähnliches umfassen.

Weiterhin ist eine Blende 9 zwischen dem Anodenraum und einem Bereich, durch welchen die Klammern 10 geführt werden, angeordnet. Durch die Blende 9 wird die elektrolytische Abscheidung von Material auf den Klammern 10 verringert. Eine weitere Verringerung der Abscheidung von Material auf den Klammern 10 kann erreicht werden, indem die Klammern 10 mit einer Kunststoffabschirmung versehen werden, wie es in der WO 99/10568 beschrieben ist.

Wie es aus Fig. 5 erkennbar ist, ist das umlaufende Antriebsmittel 20 oberhalb der Transportebene 2 des Behandlungsgutes 1 angeordnet. Auf eine genaue Darstellung der Anbringung der Klammern 10 an dem umlaufenden Antriebsmittel 20 und der Ausgestaltung der Klammer 10 wurde in Fig. 5 aus Gründen der Übersichtlichkeit verzichtet.

Wie in Fig. 5 dargestellt, ist an den Klammern 10 ein weiteres Führungselement 42 angebracht, welches sich im Wesentlichen auf Höhe der Transportebene 2 befindet. Ähnlich den Führungselementen 32a, 32b, welche anhand von Fig. 4A und 4B beschrieben wurden, ist das Führungselement 42 während der Bewegung der Klammer 10 entlang des Transportweges 4 in einer Führungsnut 44 aufgenommen. Das Führungselement 42 und die Führungsnut 44 gewährleisten eine besonders effektive Führung der Klammer 10, da ein vergrößerter Abstand bezüglich des Anbringungspunktes der Klammer 10 an dem umlaufenden Antriebsmittel 20 besteht. Wie für die Führungselemente 32a, 32b und die Führungsnuten 34a, 34b beschrieben, ist das Führungselement 42 vorzugsweise aus Metall ausgebildet, während die Führungsnuten 44 aus einem Kunststoffmaterial besteht oder mit einem solchen ausgekleidet ist. Da sich das Führungselement 42 im Wesentlichen auf einer Höhe mit der Transportebene 2 befindet und sich somit unterhalb des Flüssigkeitsspiegels der Elektrolyselösung in der Elektrolyseanlage befinden kann, ist es bevorzugt, eine elektrische Isolierung zwischen dem Führungselement 42 und der Klammer 10 vorzusehen. Auf diese Weise wird die elektrolytische Abscheidung von Material auf dem Führungselement 42 verhindert.

Weiterhin ist in Fig. 5 ein Kontakt 15a der Klammer 10 dargestellt, welcher sich zur Zuführung eines Stroms in die Klammer 10 in gleitendem oder rollendem Kontakt mit einer Stromschiene 15b befindet. Der Kontakt 15a wird vorzugsweise durch Federkraft auf der Stromschiene 15b gehalten. Der Kontakt 15a ist an dem unteren Klammerteil 18 befestigt und zur Übertragung des Stroms auf das obere Klammerteil 16 ist eine flexible Leitung 13 vorgesehen.

Durch den Kontakt 15a und die fest angeordnete Stromschiene 15b wird somit ein Stromkontakt zu der Klammer 10 bereitgestellt. Der Stromkontakt zu der Klammer 10 ist vorzugsweise unabhängig von der Bewegung der Klemmflächen 17, 19 bezüglich der Transportebene 2 steuerbar. Auf diese Weise ist es möglich, die Stromzufuhr zu den Klemmflächen 17, 19 der Klammer 10 erst dann zu aktivieren, wenn die Klammer 10 fest und zuverlässig geschlossen ist, so dass ein unkontrollierter Stromfluss oder Überschläge vermieden werden. Die Steuerung des Stromkontakts kann beispielsweise mechanisch über den Schleifkontakt 15a und die Stromschiene 15b erfolgen.

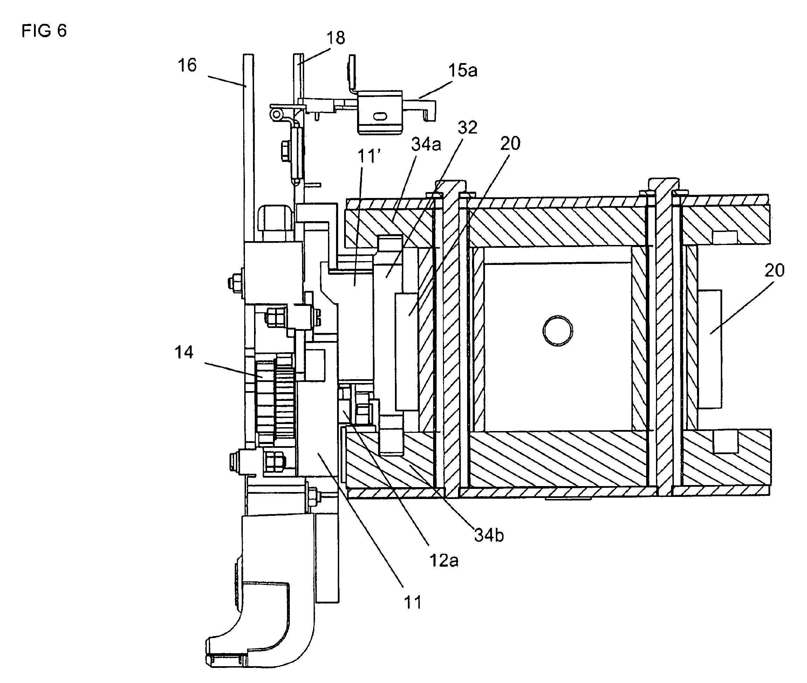

Fig. 6 zeigt eine vergrößerte Querschnittsansicht der Anbringung der Klammer 10 in der Elektrolyseanlage. Insbesondere ist in Fig. 6 die Verbindung des Basisteils 11 der Klammer 10 mit dem Rückenteil 11' erkennbar, welches wiederum über das Anbringungsteil 32 mit dem Antriebsmittel 20 verbunden ist. Weiterhin ist aus Fig. 6 ersichtlich, dass das Mitnehmerrad 12a und die Drehscheibe 14 der Klammer 10 im Bereich von Führungsmitteln zum Führen der Bewegung der Klammer 10 angeordnet sind. Insbesondere befindet sich das Mitnehmerrad 12a im Wesentlichen auf einer Höhe mit der Führungsnut 34b, so dass durch den Eingriff des Mitnehmerrads 12a mit der Zahnstange 12d, welche vorzugsweise an der Führungsnut 34b angebracht ist, keine Hebelkräfte auf die Klammer 10 ausgeübt werden bzw. die ausgeübten Hebelkräfte aufgefangen werden, ohne dass es zu einer Verkippung der Klammer 10 kommt.

An der vorhergehend beschriebenen Vorrichtung sind verschiedenartige Modifikationen möglich. So muss beispielsweise die Transportebene 2 nicht horizontal ausgerichtet sein. Wo Relativbewegungen zwischen Teilen auftreten, z. B. zwischen Antriebsmittel und Führungsnut, können zur Reduzierung der Reibung entsprechende Lager, z. B. Gleit- oder Rollenlager, eingesetzt werden. Die Bewegung der unteren Klemmfläche 19 und der oberen Klemmfläche 17 bezüglich der Transportebene 2 kann zeitgleich oder zeitversetzt erfolgen. Weiterhin können auch alternative Betätigungsmittel zum Öffnen bzw. Schließen der Klammern zum Einsatz kommen. Die Betätigungsmittel können derart ausgestaltet sein, dass sie die zum Öffnen bzw. Schließen der Klammer benötigte Energie nicht aus dem Klammerantrieb, d. h. aus der Bewegung der Klammer beziehen, und hierfür zum Beispiel einen pneumatischen Antrieb, einen hydraulischen Antrieb, einen Elektroantrieb, einen Magnetantrieb oder eine alternative mechanische Lösung umfassen. Es kann auch eine pleuelartige Verbindung zwischen der Drehscheibe 14 und dem Klammerteil 18 vorgesehen sein, so dass auf die Feder 18b verzichtet werden kann. Die pleuelartige Verbindung ist dann vorzugsweise derart ausgestaltet, dass die untere Klemmfläche 19 durch Rotation der Drehscheibe 14 an die Transportebene 2 herangeführt wird, während die Einklemmung des Behandlungsgutes durch Federkraft über das obere Klammerteil 16 erfolgt. Auf diese Weise kann die zum Öffnen der Klammer 10 benötigte Kraft verringert werden, und ein Anschlag zur Begrenzung der Bewegung der unteren Klemmfläche 19 ist nicht erforderlich.

### BEZUGSZEICHENLISTE

- 1: Behandlungsgut
- 2: Transportebene
- 3: Transportmittel
- 4: Transportweg
- 4a: Anfang des Transportweges
- 4b: Ende des Transportweges
- 5: Klemmrichtung
- 6a, 6b: Führungselemente
- 7a, 7b: Stromzuführung
- 9: Blende
- 10: Klammer
- 11: Basisteil
- 11': Rückenteil
- 11a, 11b: Halterungsteil
- 12a: Mitnehmerrad
- 12b: Zahnstange
- 13: flexible Leitung
- 14: Drehscheibe
- 15a: Kontakt
- 15b: Stromschiene
- 16: oberes Klammerteil
- 16a: Führungsteil
- 16b: Feder
- 17: obere Klemmfläche
- 18: unteres Klammerteil
- 18a: Führungsteil
- 18b: Feder
- 19: untere Klemmfläche
- 20: Antriebsmittel
- 22: Rolle
- 32: Anbringungsteil
- 32a, 32b: Führungselement
- 34a, 34b: Führungsnut
- 42: Führungselement
- 44: Führungsnut

## Patentansprüche

1. Verfahren zum Transport eines Behandlungsgutes (1) in einer Elektrolyseanlage, wobei der Transport des Behandlungsgutes (1) entlang eines Transportweges (4) in einer definierten Transportebene (2) erfolgt, umfassend die Schritte:
Greifen des Behandtungsgutes (1) am Anfang (4a) des Transportweges (4) durch Einklemmung des Behandlungsgutes (1) zwischen einer ersten Klemmfläche (19) und einer zweiten Klemmfläche (17),
Bewegen der ersten Klemmfläche (19) und der zweiten Klemmfläche (17) entlang des Transportweges (4), und
Freigeben des Behandlungsgutes (1) am Ende (4b) des Transportweges (4) durch Lösen der Einklemmung des Behandlungsgutes (1),
wobei das Verfahren ein Bewegen sowohl der ersten Klemmfläche (19) als auch der zweiten Klemmfläche (17) bezüglich der Transportebene umfasst, um das Behandlungsgut (1) zu greifen bzw. freizugeben,
**dadurch gekennzeichnet,**
**dass** bei Einklemmung des Behandlungsgutes (1) die erste Klemmfläche (19) in der Transportebene (2) liegt.

2. Verfahren nach Anspruch 1,
**dadurch gekennzeichnet,**
**dass** das Verfahren ein elektrisches Kontaktieren des Behandlungsgutes (1) über mindestens eine der Klemmflächen (17, 19) umfasst.

3. Verfahren nach Anspruch 2,
**dadurch gekennzeichnet,**
**dass** über die mindestens eine Klemmfläche (17, 19) dem Behandlungsgut (1) ein Strom zugeführt wird.

4. Verfahren nach einem der Ansprüche 1 bis 3,
**dadurch gekennzeichnet,**
**dass** zur Einklemmung des Behandlungsgutes (1) die erste Klemmfläche (19) und die zweite Klemmfläche (17) mit einer Kraft auf das Behandlungsgut (1) gedrückt wird, welche bezogen auf die Klemmfläche zwischen 0,2 N/mm² und 3,5 N/mm² beträgt.

5. Verfahren nach einem der vorhergehenden Ansprüche,
**dadurch gekennzeichnet,**
**dass** die Bewegung der ersten Klemmfläche (19) und der zweiten Klemmfläche (17) bezüglich der Transportebene (2) zeitgleich erfolgt.

6. Verfahren nach einem der Ansprüche 1 bis 4,
**dadurch gekennzeichnet,**
**dass** die Bewegung der ersten Klemmfläche (19) und der zweiten Klemmfläche (17) bezüglich der Transportebene (2) zeitversetzt erfolgt.

7. Verfahren nach einem der vorhergehenden Ansprüche,
**dadurch gekennzeichnet,**
**dass** sich die Transportebene (2) im Wesentlichen horizontal erstreckt.

8. Klammer (10) zum Transport eines Behandlungsgutes (1) in einer Elektrolyseanlage, wobei die Klammer (10) dazu ausgestaltet ist, entlang eines Transportweges (4) beweglich angeordnet zu sein, um das Behandlungsgut (1) entlang des Transportweges (4) in einer definierten Transportebene (2) zu transportieren, wobei die Klammer (10) am Anfang (4a) des Transportweges (4) in einen geschlossenen Zustand gebracht wird, um das Behandlungsgut (1) zu greifen, und am Ende (4b) des Transportweges (4) in einen offenen Zustand gebracht wird, um das Behandlungsgut (1) freizugeben,
wobei die Klammer (10) eine erste Klemmfläche (19), welche auf einer Seite der Transportebene (2) angeordnet ist, und eine zweite Klemmfläche (17), welche auf der gegenüberliegenden Seite der Transportebene (2) angeordnet ist, umfasst, und
wobei die Klammer (10) derart ausgestaltet ist, dass sowohl die erste Klemmfläche (19) als auch die zweite Klemmfläche (17) bezüglich der Transportebene (2) beweglich ist, um die Klammer (10) zum Greifen des Behandlungsgutes (1) in den geschlossenen Zustand zu bringen bzw. die Klammer (10) zum Freigeben des Behandlungsgutes (1) in den offenen Zustand zu bringen,
**dadurch gekennzeichnet,**
**dass** im geschlossenen Zustand der Klammer (10) die erste Klemmfläche (19) in der Transportebene (2) liegt.

9. Klammer (10) nach Anspruch 8,
**dadurch gekennzeichnet,**
**dass** die Klammer (10) ein erstes Klammerteil (18) mit der ersten Klemmfläche (19), ein zweites Klammerteil (16) mit der zweiten Klemmfläche (17) und ein Basisteil (11) umfasst,
wobei das Basisteil (11) einen Anbringungsbereich zur Anbringung an einem Antriebsmittel (20) aufweist, und
wobei sowohl das erste Klammerteil (18) als auch das zweite Klammerteil (16) beweglich an dem Basisteil (11) angebracht ist.

10. Klammer (10) nach Anspruch 8 oder 9,
**dadurch gekennzeichnet,**
**dass** die Klammer (10) derart ausgestaltet ist, dass sie durch eine Federkraft in dem geschlossenen Zustand gehalten wird und das Öffnen der Klammer (10) mittels der Betätigungsmittel (12a, 12b) gegen die Federkraft erfolgt.

11. Klammer (10) nach einem der Ansprüche 8 bis 10,
**dadurch gekennzeichnet,**
**dass** die Klammer (10) ein Mitnehmerrad (12b) und Umsetzungsmittel (14, 16a, 16b) zur Umsetzung einer Rotationsbewegung des Mitnehmerrads (12a) in die Bewegung der Klemmflächen (17, 19) umfasst.

12. Klammer (10) nach Anspruch 11,
**dadurch gekennzeichnet,**
**dass** die Umsetzungsmittel (14, 16a, 16b) eine in Rotation mit dem Mitnehmerrad (12a) gekoppelte Drehscheibe (14) umfassen, welche eine äußere Umfangsfläche aufweist, deren radialer Abstand zu der Drehachse der Drehscheibe (14) entlang der Umfangsrichtung variiert, wobei ein mit der ersten Klemmfläche (19) bewegliches erstes Führungsteil (16b) und/oder ein mit der zweiten Klemmfläche (17) bewegliches zweites Führungsteil (16a) jeweils durch eine Federkraft in Kontakt mit einem Bereich der äußeren Umfangsfläche der Drehscheibe (14) gehalten sind.

13. Klammer (10) nach Anspruch 11 oder 12,
**dadurch gekennzeichnet,**
**dass** die Klammer (10) Führungsmittel (32a, 32b) zum Führen der Bewegung der Klammer (10) entlang des Transportweges (4) umfasst, wobei das Mitnehmerrad (12b) im Bereich der Führungsmittel angeordnet ist.

14. Klammer (10) nach einem der Ansprüche 8 bis 13,
**dadurch gekennzeichnet,**
**dass** die Klammer (10) einen Anschlag umfasst, welcher die Bewegung der ersten Klemmfläche (19) in Richtung der Transportebene (2) derart begrenzt, dass die erste Klemmfläche (19) nicht über die Transportebene (2) hinaus beweglich ist.

15. Klammer (10) nach einem der Ansprüche 8 bis 14,
**dadurch gekennzeichnet,**
**dass** die Klammer (10) einen Anschlag umfasst, welcher die Bewegung der zweiten Klemmfläche (17) in Richtung der Transportebene (2) derart begrenzt, dass die zweite Klemmfläche (17) nicht über die Transportebene (2) hinaus beweglich ist.

16. Klammer (10) nach einem der Ansprüche 8 bis 15,
**dadurch gekennzeichnet,**
**dass** die Klammer (10) einen Kontakt (15a) umfasst, welcher dazu ausgestaltet ist, in gleitenden oder rollenden Kontakt mit einer fest angeordneten Stromschiene (15b) zu kommen, um einen Stromkontakt zur Zuführung eines elektrischen Stroms zu den Klemmflächen (17, 19) bereitzustellen.

17. Klammer (10) nach Anspruch 16,
**dadurch gekennzeichnet,**
**dass** der Stromkontakt unabhängig von der Bewegung der ersten Klemmfläche (19) und der zweiten Klemmfläche (17) steuerbar ist.

18. Klammer (10) nach einem der Ansprüche 8 bis 17,
**dadurch gekennzeichnet,**
**dass** die Klammer (10) zur Durchführung des Verfahrens nach einem der Ansprüche 1 bis 7 ausgestaltet ist.

19. Vorrichtung zum Transport eines Behandlungsgutes (1) in einer Elektrolyseanlage,
wobei die Vorrichtung derart ausgestaltet ist, dass der Transport des Behandlungsgutes (1) entlang eines Transportweges (4) in einer definierten Transportebene (2) erfolgt, wobei die Vorrichtung eine Vielzahl von Klammern (10) umfasst, welche voneinander beabstandet entlang des Transportweges (4) beweglich angeordnet sind, wobei die Vorrichtung ein Antriebsmittel (20) zum Antrieb der Bewegung der Klammern (10) entlang des Transportweges (4) umfasst,
wobei die Vorrichtung Betätigungsmittel (12a, 12b, 14) umfasst, welche derart ausgestaltet sind, dass die Klammern (10) jeweils am Anfang (4a) des Transportweges (4) in einen geschlossenen Zustand gebracht werden, um das Behandlungsgut (1) am Anfang (4a) des Transportweges (4) zu greifen, und dass die Klammern (10) jeweils am Ende (4b) des Transportweges (4) in einen offenen Zustand gebracht werden, um das Behandlungsgut (1) freizugeben,
wobei die Klammern (10) eine erste Klemmfläche (19), welche auf einer Seite der Transportebene (2) angeordnet ist, und eine zweite Klemmfläche (17), welche auf der gegenüberliegenden Seite der Transportebene (2) angeordnet ist, umfassen, und wobei die Klammern (10) derart ausgestaltet sind, dass sowohl die erste Klemmfläche (19) als auch die zweite Klemmfläche (17) bezüglich der Transportebene (2) beweglich ist, um die Klammern (10) zum Greifen des Behandlungsgutes (1) in den geschlossenen Zustand zu bringen bzw. die Klammern (10) zum Freigeben des Behandlungsgutes (1) in den offenen Zustand zu bringen,
**dadurch gekennzeichnet,**
**dass** im geschlossenen Zustand der Klammer (10) die erste Klemmfläche (19) in der Transportebene (2) liegt.

20. Vorrichtung nach Anspruch 19,
**dadurch gekennzeichnet,**
**dass** die Klammern (10) jeweils nach einem der Ansprüche 8 bis 19 ausgestaltet sind.

21. Vorrichtung nach Anspruch 19 oder 20,
**dadurch gekennzeichnet,**
**dass** die Betätigungsmittel (12a, 12b) derart ausgestaltet sind, dass sie die Bewegung der Klammern (10) entlang des Transportweges (4) mechanisch mit der Bewegung der ersten Klemmfläche (19) und der zweiten Klemmfläche (17) bezüglich der Transportebene (2) koppeln.

22. Vorrichtung nach einem der Ansprüche 19 bis 21,
**dadurch gekennzeichnet,**
**dass** die Betätigungsmittel (12a, 12b) ein jeweils an den Klammern (10) angeordnetes Mitnehmerrad (12a) und an einer vorbestimmten Position entlang des Transportweges (4) fest angeordnete Eingriffmittel (12b) umfassen,
wobei das Mitnehmerrad (12a) und die Eingriffmittel (12b) derart angeordnet sind, dass das Mitnehmerrad (12a) mit den Eingriffmitteln (12b) in Eingriff kommt, wenn die jeweilige Klammer (10) die vorbestimmte Position durchläuft, so dass eine Rotation des Mitnehmerrads (12a) bewirkt wird.

23. Vorrichtung nach Anspruch 22,
**dadurch gekennzeichnet,**
**dass** die Eingriffmittel (12b) eine Zahnstange umfassen, welche sich entlang des Transportweges (4) über eine Länge erstreckt, welche derart bemessen ist, dass das Mitnehmerrad (12a) um einen vorbestimmten Betrag rotiert wird, wenn die Klammer (10) die vorbestimmte Position durchläuft.

24. Vorrichtung nach einem der Ansprüche 19 bis 23,
**dadurch gekennzeichnet,**
**dass** das Antriebsmittel (20) als endlos umlaufendes Antriebsmittel ausgestaltet ist.

25. Vorrichtung nach Anspruch 24,
**dadurch gekennzeichnet,**
**dass** das umlaufende Antriebsmittel (20) als Antriebsriemen aus einem flexiblen Material mit einer hohen Widerstandsfähigkeit gegenüber einer Stauchungs- und Dehnungsbelastung ausgebildet ist.

26. Vorrichtung nach Anspruch 25,
**dadurch gekennzeichnet,**
**dass** der Antriebsriemen eine Armierung umfasst.

27. Vorrichtung nach Anspruch 24,
**dadurch gekennzeichnet,**
**dass** das umlaufende Antriebsmittel (20) als Kette ausgebildet ist.

28. Vorrichtung nach einem der Ansprüche 24 bis 27,
**dadurch gekennzeichnet,**
**dass** an dem umlaufenden Antriebsmittel (20) in vorbestimmten Abständen Anbringungsteile (32) zur Anbringung der Klammern (10) befestigt sind.

29. Vorrichtung nach Anspruch 28,
**dadurch gekennzeichnet,**
**dass** zwischen den Klammern (10) und den Anbringungsteilen (32) eine Schnelllöseverbindung vorgesehen ist.

30. Vorrichtung nach einem der Ansprüche 24 bis 29,
**dadurch gekennzeichnet,**
**dass** die Vorrichtung im Anbringungsbereich der Klammern (10) an dem umlaufenden Antriebsmittel (20) mindestens eine sich parallel zum Transportweg (4) erstreckende Führungsnut (34a, 34b) umfasst, wobei die Anbringungsteile (32) und/oder die Klammern (10) jeweils mindestens ein Führungselement (32a, 32b) aufweisen, welches dazu ausgestaltet ist, während der Bewegung der jeweiligen Klammer (10) entlang des Transportweges (4) in der Führungsnut (34a, 34b) aufgenommen zu werden.

31. Vorrichtung nach einem der Ansprüche 24 bis 29,
**dadurch gekennzeichnet,**
**dass** die Vorrichtung an beiden Seiten des umlaufenden Antriebsmittels (20) jeweils eine sich parallel zum Transportweg (4) erstreckende Führungsnut (34a, 34b) umfasst, wobei die beiden Führungsnuten (34a, 34b) entgegengesetzt gerichtete Aufnahmen für entsprechende Führungselemente (32a, 32b) aufweisen, welche jeweils an den Anbringungsteilen (32) und/oder den Klammern (10) vorgesehen sind und dazu ausgestaltet sind, während der Bewegung der jeweiligen Klammer (10) entlang des Transportweges (4) in der entsprechenden Aufnahme der beiden Führungsnuten (34a, 34b) aufgenommen zu werden.

32. Vorrichtung nach einem der Ansprüche 19 bis 31,
**dadurch gekennzeichnet,**
**dass** die Vorrichtung eine sich im Wesentlichen in der Transportebene (2) und entlang des Transportweges (4) erstreckende Führungsnut (44) umfasst, wobei die Klammern (10) jeweils ein Führungselement (42) umfassen, welches dazu ausgestaltet ist, während der Bewegung der Klammern (10) entlang des Transportweges (4) in der Führungsnut (44) aufgenommen zu werden.

33. Vorrichtung nach einem der Ansprüche 30 bis 32,
**dadurch gekennzeichnet,**
**dass** die Führungselemente (32a, 32b, 42) derart bemessen sind, dass die Führungselemente (32a, 32b, 42) benachbarter Klammern (10) im Wesentlichen aneinander angrenzen, wenn sich die Klammern (10) im Bereich des Transportweges (4) befinden.

## Claims

1. Method for conveying an item to be treated (10) in an electrolysis system, the item to be treated (10) being conveyed along a conveyance path (4) in a defined conveyance plane (2), comprising the following steps:
gripping the item to be treated (10) at the start (4a) of the conveyance path (4) by clamping the item to be treated (10) between a first clamping surface (19) and a second clamping surface (17),
moving the first clamping surface (19) and the second clamping surface (17) along the conveyance path (4), and
releasing the item to be treated (10) at the end (4b) of the conveyance path (4) by unclamping the item to be treated (10),
wherein the method comprises movement both of the first clamping surface (19) and of the second clamping surface (17) with respect to the conveyance plane in order to grip or release the item to be treated (10),
**characterised in that**
when clamping the item to be treated (10), the first clamping surface (19) lies in the conveyance plane (2).

2. Method according to Claim 1, **characterised in that** the method includes electrical contacting of the item to be treated (10) via at least one of the clamping surfaces (17, 19).

3. Method according to Claim 2, **characterised in that** a current is supplied to the item to be treated (1) via the at least one clamping surface (17, 19).

4. Method according to any one of Claims 1 to 3, **characterised in that**, for clamping the item to be treated (10), the first clamping surface (19) and the second clamping surface (17) are pressed onto the item to be treated (10) with a force which, with respect to the clamping surface, is between 0.2 N/mm² and 3.5 N/mm²_{.}

5. Method according to any one of the preceding claims, **characterised in that** the movement of the first clamping surface (19) and the second clamping surface (17) with respect to the conveyance plane (2) takes place simultaneously.

6. Method according to any one of Claims 1 to 4, **characterised in that** the movement of the first clamping surface (19) and the second clamping surface (17) with respect to the conveyance plane (2) takes place in a delayed manner.

7. Method according to any one of the preceding claims, **characterised in that** the conveyance plane (2) extends substantially horizontally.

8. Clamp (10) for conveying an item to be treated (1) in an electrolysis system, the clamp (10) being configured to be arranged movably along a conveyance path (4) in order to convey the item to be treated (1) along the conveyance path (4) in a defined conveyance plane (2), the clamp (10) being brought into a closed state at the start (4a) of the conveyance path (4) in order to grip the item to be treated (1) and being brought into an open state at the end (4b) of the conveyance path (4) in order to release the item to be treated (1),
the clamp (10) comprising a first clamping surface (19), arranged on one side of the conveyance plane (2), and a second clamping surface (17), arranged on the opposing side of the conveyance plane (2), and
the clamp (10) being configured in such a way that both the first clamping surface (19) and the second clamping surface (17) are movable with respect to the conveyance plane (2) in order to bring the clamp (10) into the closed state for gripping the item to be treated (1) or to bring the clamp (10) into the open state for releasing the item to be treated (1),
**characterised in that**
in the closed state of the clamp (10), the first clamping surface (19) lies in the conveyance plane (2).

9. Clamp (10) according to Claim 8, **characterised in that** the clamp (10) comprises a first clamp portion (18) with the first clamping surface (19), a second clamp portion (16) with the second clamping surface (17) and a base portion (11),
the base portion (11) comprising an attachment region for attachment to a drive means (20), and
both the first clamp portion (18) and the second clamp portion (16) being movably attached to the base portion (11).

10. Clamp (10) according to Claim 8 or Claim 9, **characterised in that** the clamp (10) is configured in such a way that it is held in the closed state by a resilient force and the clamp (10) is opened counter to the resilient force using the actuating means (12a, 12b).

11. Clamp (10) according to any one of Claims 8 to 10, **characterised in that** the clamp (10) comprises an entrainment wheel (12b) and conversion means (14, 16a, 16b) for converting a rotational movement of the entrainment wheel (12a) into the movement of the clamping surfaces (17, 19).

12. Clamp (10) according to Claim 11, **characterised in that** the conversion means (14, 16a, 16b) comprise a rotary disc (14) rotationally coupled to the entrainment wheel (12a) and having an outer circumferential surface, of which the radial distance from the axis of rotation of the rotary disc (14) varies along the circumferential direction, a first guide portion (16b), movable with the first clamping surface (19), and/or a second guide portion (16a), movable with the second clamping surface (17), being respectively held, by a resilient force, in contact with a region of the outer circumferential surface of the rotary disc (14).

13. Clamp (10) according to Claim 11 or Claim 12, **characterised in that** the clamp (10) comprises guide means (32a, 32b) for guiding the movement of the clamp (10) along the conveyance path (4), the entrainment wheel (12b) being arranged in the region of the guide means.

14. Clamp (10) according to any one of Claims 8 to 13, **characterised in that** the clamp (10) comprises a stop which limits the movement of the first clamping surface (19) in the direction of the conveyance plane (2) in such a way that the first clamping surface (19) may not move beyond the conveyance plane (2).

15. Clamp (10) according to any one of Claims 8 to 14, **characterised in that** the clamp (10) comprises a stop which limits the movement of the second clamping surface (17) in the direction of the conveyance plane (2) in such a way that the second clamping surface (17) may not move beyond the conveyance plane (2).

16. Clamp (10) according to any one of Claims 8 to 15, **characterised in that** the clamp (10) comprises a contact (15a) which is configured to enter into sliding or rolling contact with a fixed conductor rail (15b) in order to provide a current contact for supplying an electrical current to the clamping surfaces (17, 19).

17. Clamp (10) according to Claim 16, **characterised in that** the current contact is controllable independently of the movement of the first clamping surface (19) and the second clamping surface (17).

18. Clamp (10) according to any one of Claims 8 to 17, **characterised in that** the clamp (10) is configured for carrying out the method according to any one of Claims 1 to 7.

19. Device for conveying an item to be treated (1) in an electrolysis system, the device being configured in such a way that the item to be treated (1) is conveyed along a conveyance path (4) in a defined conveyance plane (2),
the device comprising a plurality of clamps (10) which are movably arranged at a distance from one another along the conveyance path (4), the device comprising a drive means (20) for driving the movement of the clamps (10) along the conveyance path (4),
the device comprising actuating means (12a, 12b, 14) which are configured in such a way that at the start (4a) of the conveyance path (4), in each case, the clamps (10) are brought into a closed state in order to grip the item to be treated (1) at the start (4a) of the conveyance path (4) and that at the end (4b) of the conveyance path (4), in each case, the clamps (10) are brought into an open state in order to release the item to be treated (1),
the clamps (10) comprising a first clamping surface (19), arranged on one side of the conveyance plane (2), and a second clamping surface (17), arranged on the opposing side of the conveyance plane (2), and
the clamps (10) being configured in such a way that both the first clamping surface (19) and the second clamping surface (17) are movable with respect to the conveyance plane (2) in order to bring the clamps (10) into the closed state for gripping the item to be treated (1) or to bring the clamps (10) into the open state for releasing the item to be treated (1),
**characterised in that**
in the closed state of the clamp (10), the first clamping surface (19) lies in the conveyance path (4).

20. Device according to Claim 19, **characterised in that** the clamps (10) are respectively configured according to any one of Claims 8 to 19.

21. Device according to Claim 19 or Claim 20, **characterised in that** the actuating means (12a, 12b) are configured in such a way that they mechanically couple the movement of the clamps (10) along the conveyance path (4) to the movement of the first clamping surface (19) and the second clamping surface (17) with respect to the conveyance plane (2).

22. Device according to any one of Claims 19 to 21, **characterised in that** the actuating means (12a, 12b) comprise an entrainment wheel (12a), respectively arranged on the clamps (10), and engagement means (12b), fixed at a predetermined position along the conveyance path (4), the entrainment wheel (12a) and the engagement means (12b) being arranged in such a way that the entrainment wheel (12a) enters into engagement with the engagement means (12b) when the respective clamp (10) passes through the predetermined position, thus causing rotation of the entrainment wheel (12a).

23. Device according to Claim 22, **characterised in that** the engagement means (12b) comprise a rack extending along the conveyance path (4) over a length, the dimensions of which are such that the entrainment wheel (12a) is rotated by a predetermined amount when the clamp (10) passes through the predetermined position.

24. Device according to any one of Claims 19 to 23, **characterised in that** the drive means (20) is configured as a continuously revolving drive means.

25. Device according to Claim 24, **characterised in that** the revolving drive means (20) is configured as a drive belt made from a flexible material having high resistance to compressive and tensile loads.

26. Device according to Claim 25, **characterised in that** the drive belt comprises a reinforcement.

27. Device according to Claim 24, **characterised in that** the revolving drive means (20) is configured as a chain.

28. Device according to any one of Claims 24 to 27, **characterised in that** attachment portions (32) for attaching the clamps (10) are fastened to the revolving drive means (20) at predetermined distances.

29. Device according to Claim 28, **characterised in that** a quick-release connection is provided between the clamps (10) and the attachment portions (32).

30. Device according to any one of Claims 24 to 29, **characterised in that** the device comprises, in the region for attachment of the clamps (10) to the revolving drive means (20), at least one guide groove (34a, 34b) extending parallel to the conveyance path (4), the attachment portions (32) and/or the clamps (10) respectively having at least one guide element (32a, 32b) configured to be received, during the movement of the respective clamp (10) along the conveyance path (4), in the guide groove (34a, 34b).

31. Device according to any one of Claims 24 to 29, **characterised in that** the device comprises, on both sides of the revolving drive means (20), a respective guide groove (34a, 34b) extending parallel to the conveyance path (4), the two guide grooves (34a, 34b) having opposing recesses for corresponding guide elements (32a, 32b) which are respectively provided on the attachment portions (32) and/or the clamps (10) and are configured to be received, during the movement of the respective clamp (10) along the conveyance path (4), in the corresponding recess of the two guide grooves (34a, 34b).

32. Device according to any one of Claims 19 to 31, **characterised in that** the device comprises a guide groove (44) extending substantially in the conveyance plane (2) and along the conveyance path (4), the clamps (10) comprising a respective guide element (42) configured to be received, during the movement of the clamps (10) along the conveyance path (4), in the guide groove (44).

33. Device according to any one of Claims 30 to 32, **characterised in that** the dimensions of the guide elements (32a, 32b, 42) are such that the guide elements (32a, 32b, 42) of adjacent clamps (10) substantially abut one another when the clamps (10) are located in the region of the conveyance path (4).

## Revendications

1. Procédé pour le transport d'un produit à traiter (1) dans une installation d'électrolyse, le transport du produit à traiter (1) étant effectué le long d'une voie de transport (4) sur un plan de transport (2) défini, ledit procédé comprenant les étapes suivantes :
saisie du produit à traiter (1) au début (4a) de la voie de transport (4) par serrage du produit à traiter (1) entre une première surface de serrage (19) et une deuxième surface de serrage (17),
déplacement de la première surface de serrage (19) et de la deuxième surface de serrage (17) le long de la voie de transport (4), et
libération du produit à traiter (1) à la fin (4b) de la voie de transport (4) par desserrage du produit à traiter (1),
le procédé comprenant un déplacement de la première surface de serrage (19) ainsi que de la deuxième surface de serrage (17) par rapport au plan de transport, pour saisir ou de libérer le produit à traiter (1),
**caractérisé**
**en ce que** la première surface de serrage (19) repose sur le plan de transport (2) lorsque le produit à traiter (1) est serré.

2. Procédé selon la revendication 1,
**caractérisé**
**en ce que** le procédé comprend une mise en contact électrique du produit à traiter (1) par au moins une des surfaces de serrage (17, 19).

3. Procédé selon la revendication 2,
**caractérisé**
**en ce qu'**un courant est conduit vers le produit à traiter (1) par la ou les surfaces de serrage (17, 19).

4. Procédé selon l'une des revendications 1 à 3,
**caractérisé**
**en ce que** pour le serrage du produit à traiter (1), la première surface de serrage (19) et la deuxième surface de serrage (17) sont appuyées contre le produit à traiter (1) avec une force comprise entre 0,2 N/mm² et 3,5 N/mm² par rapport à la surface de serrage.

5. Procédé selon l'une des revendications précédentes,
**caractérisé**
**en ce que** les déplacements de la première surface de serrage (19) et de la deuxième surface de serrage (17) par rapport au plan de transport (2) sont simultanés.

6. Procédé selon l'une des revendications 1 à 4,
**caractérisé**
**en ce que** les déplacements de la première surface de serrage (19) et de la deuxième surface de serrage (17) par rapport au plan de transport (2) sont temporellement décalés.

7. Procédé selon l'une des revendications précédentes,
**caractérisé**
**en ce que** le plan de transport (2) s'étend sensiblement à l'horizontale.

8. Pince (10) pour le transport d'un produit à traiter (1) dans une installation d'électrolyse, ladite pince (10) étant réalisée de manière à être mobile le long d'une voie de transport (4), pour transporter le produit à traiter (1) sur un plan de transport (2) défini le long de la voie de transport (4), ladite pince (10) étant mise en état de fermeture pour saisir le produit à traiter (1) au début (4a) de la voie de transport (4), et mise en état d'ouverture pour libérer le produit à traiter (1) à la fin (4b) de la voie de transport (4),
ladite pince (10) comprenant une première surface de serrage (19) située d'un côté du plan de transport (2), et une deuxième surface de serrage (17), située de l'autre côté du plan de transport (2), et
ladite pince (10) étant réalisée de manière que la première surface de serrage (19) ainsi que la deuxième surface de serrage (17) soient mobiles par rapport au plan de transport (2), pour mettre la pince (10) en état de fermeture pour saisir le produit à traiter (1) ou pour mettre la pince (10) en état d'ouverture pour libérer le produit à traiter (1),
**caractérisée**
**en ce qu'**en état de fermeture de ladite pince (10), la première surface de serrage (19) repose sur le plan de transport (2).

9. Pince (10) selon la revendication 8,
**caractérisée**
**en ce que** ladite pince (10) comprend une première pièce de pince (18) avec la première surface de serrage (19), une deuxième pièce de pince (16) avec la deuxième surface de serrage (17) et une pièce de base (11), ladite pièce de base (11) comportant une zone d'application destinée à être appliquée contre un moyen d'entraînement (20), et la première pièce de pince (18) ainsi que la deuxième pièce de pince (16) étant appliquées de manière à être mobiles contre la pièce de base (11).

10. Pince (10) selon la revendication 8 ou la revendication 9,
**caractérisée**
**en ce que** ladite pince (10) est réalisée de manière à être maintenue en état de fermeture par une force de ressort et en ce que l'ouverture de la pince (10) est effectuée par des moyens d'actionnement (12a, 12b) opposés à la force de ressort.

11. Pince (10) selon l'une des revendications 8 à 10,
**caractérisée**
**en ce que** ladite pince (10) comprend une roue entraîneuse (12b) et des moyens de conversion (14, 16a, 16b) pour la conversion d'un mouvement de rotation de la roue entraîneuse (12a) en déplacement des surfaces de serrage (17, 19).

12. Pince (10) selon la revendication 11,
**caractérisée**
**en ce que** les moyens de conversion (14, 16a, 16b) comprennent un disque rotatif (14) accouplé en rotation à la roue entraîneuse (12a), lequel présente une surface périphérique extérieure dont la distance radiale à l'axe de rotation du disque rotatif (14) varie le long de la direction périphérique, une première pièce de guidage (16b) déplaçable avec la première surface de serrage (19) et/ou une deuxième pièce de guidage (16a) déplaçable avec la deuxième surface de serrage (17) étant respectivement maintenues par une force de ressort au contact d'une zone de la surface périphérique extérieure du disque rotatif (14).

13. Pince (10) selon la revendication 11 ou la revendication 12,
**caractérisée**
**en ce que** ladite pince (10) comprend des moyens de guidage (32a, 32b) pour le guidage du déplacement de la pince (10) le long de la voie de transport (4), la roue entraîneuse (12b) étant disposée au niveau des moyens de guidage.

14. Pince (10) selon l'une des revendications 8 à 13,
**caractérisée**
**en ce que** ladite pince (10) comprend une butée, qui limite le déplacement de la première surface de serrage (19) en direction du plan de transport (2) de manière que ladite première surface de serrage (19) ne soit pas déplaçable au-dessus du plan de transport (2).

15. Pince (10) selon l'une des revendications 8 à 14,
**caractérisée**
**en ce que** ladite pince (10) comprend une butée, qui limite le déplacement de la deuxième surface de serrage (17) en direction du plan de transport (2) de manière que ladite deuxième surface de serrage (17) ne soit pas déplaçable au-dessus du plan de transport (2).

16. Pince (10) selon l'une des revendications 8 à 15,
**caractérisée**
**en ce que** ladite pince (10) comprend un contact (15a) réalisé de manière à entrer en contact par glissement ou roulement avec une barre conductrice (15b) fixe, pour générer un contact de courant pour la conduction d'un courant électrique vers les surfaces de serrage (17, 19).

17. Pince (10) selon la revendication 16,
**caractérisée**
**en ce que** le contact de courant peut être commandé indépendamment du déplacement de la première surface de serrage (19) et de la deuxième surface de serrage (17).

18. Pince (10) selon l'une des revendications 8 à 17,
**caractérisée**
**en ce que** ladite pince (10) est réalisée pour l'exécution du procédé selon l'une des revendications 1 à 7.

19. Dispositif de transport d'un produit à traiter (1) dans une installation d'électrolyse, ledit dispositif étant réalisé de telle manière que le transport du produit à traiter (1) est effectué le long d'une voie de transport (4) sur un plan de transport (2),
ledit dispositif comprenant une pluralité de pinces (10) espacées l'une de l'autre et mobiles le long de la voie de transport (4), ledit dispositif comprenant un moyen d'entraînement (20) pour provoquer le déplacement des pinces (10) le long de la voie de transport (4),
ledit dispositif comprenant des moyens d'actionnement (12a, 12b, 14) réalisés de manière à mettre les pinces (10) respectives en état de fermeture au début (4a) de la voie de transport (4) pour saisir le produit à traiter (1) au début (4a) de la voie de transport (4), et mettre les pinces (10) respectives en état d'ouverture à la fin (4b) de la voie de transport (4) pour libérer le produit à traiter (1),
les pinces (10) comprenant une première surface de serrage (19), située d'un côté du plan de transport (2), et une deuxième surface de serrage (17), située de l'autre côté du plan de transport (2), et
les pinces (10) étant réalisées de manière que la première surface de serrage (19) ainsi que la deuxième surface de serrage (17) soient mobiles par rapport au plan de transport (2), pour mettre les pinces (10) en état de fermeture pour saisir le produit à traiter (1) ou pour mettre les pinces (10) en état d'ouverture pour libérer le produit à traiter (1) les pinces (10),
**caractérisé**
**en ce qu'**en état de fermeture des pinces (10), la première surface de serrage (19) repose sur le plan de transport (2).

20. Dispositif selon la revendication 19,
**caractérisé**
**en ce que** les pinces (10) sont réalisées chacune selon l'une des revendications 8 à 19.

21. Dispositif selon la revendication 19 ou la revendication 20,
**caractérisé**
**en ce que** les moyens d'actionnement (12a, 12b) sont réalisés de manière à coupler mécaniquement le déplacement des pinces (10) le long de la voie de transport (4) au déplacement de la première surface de serrage (19) et de la deuxième surface de serrage (17) par rapport au plan de transport (2).

22. Dispositif selon l'une des revendications 19 à 21,
**caractérisé**
**en ce que** les moyens d'actionnement (12a, 12b) comprennent une roue entraîneuse (12a) disposée sur chaque pince (10) et des moyens d'engrènement (12b) fixement disposés à un emplacement défini le long de la voie de transport (4), la roue entraîneuse (12a) et les moyens d'engrènement (12b) étant disposés de telle manière que la roue entraîneuse (12a) entre en contact avec les moyens d'engrènement (12b) lorsque la pince (10) correspondante dépasse l'emplacement défini, de manière à entraîner une rotation de la roue entraîneuse (12a).

23. Dispositif selon la revendication 22,
**caractérisé**
**en ce que** les moyens d'engrènement (12b) comprenant une crémaillère s'étendant le long de la voie de transport (4) sur une longueur prévue de manière à entraîner une rotation de valeur définie de la roue entraîneuse (12a) lorsque la pince (10) dépasse l'emplacement défini.

24. Dispositif selon l'une des revendications 19 à 23,
**caractérisé**
**en ce que** le moyen d'entraînement (20) est réalisé comme moyen d'entraînement à rotation sans fin.

25. Dispositif selon la revendication 24,
**caractérisé**
**en ce que** le moyen d'entraînement (20) rotatif est réalisé comme courroie de transmission en matériau flexible de résistance élevée à une contrainte par écrasement et dilatation.

26. Dispositif selon la revendication 25,
**caractérisé**
**en ce que** la courroie de transmission comprend une armature.

27. Dispositif selon la revendication 24,
**caractérisé**
**en ce que** le moyen d'entraînement (20) rotatif est réalisé comme chaîne.

28. Dispositif selon l'une des revendications 24 à 27,
**caractérisé**
**en ce que** des pièces d'application (32) destinées à l'application des pinces (10) sont fixées à intervalles définis sur le moyen d'entraînement (20) rotatif.

29. Dispositif selon la revendication 28,
**caractérisé**
**en ce qu'**un raccord à desserrage rapide est prévu entre les pinces (10) et les pièces d'application (32).

30. Dispositif selon l'une des revendications 24 à 29,
**caractérisé**
**en ce que** le dispositif comprend au moins une rainure de guidage (34a, 34b) s'étendant parallèlement à la voie de transport (4) dans la zone d'application des pinces (10) sur le moyen d'entraînement (20) rotatif, les pièces d'application (32) et/ou les pinces (10) comportant au moins un élément de guidage (32a, 32b) respectif réalisé de manière à être logé dans la rainure de guidage (34a, 34b) pendant le déplacement de la pince (10) correspondante le long de la voie de transport (4).

31. Dispositif selon l'une des revendications 24 à 29,
**caractérisé**
**en ce que** le dispositif comprend sur chacun des deux côtés du moyen d'entraînement rotatif (20) une rainure de guidage (34a, 34b) s'étendant parallèlement à la voie de transport (4), les deux rainures de guidage (34a, 34b) comportant des logements orientés en sens contraires pour des éléments de guidage (32a, 32b) correspondants, respectivement prévus sur les pièces d'application (32) et/ou les pinces (10) et réalisés de manière à être logés dans les logements correspondants des deux rainures de guidage (34a, 34b) pendant le déplacement de la pince (10) correspondante le long de la voie de transport (4).

32. Dispositif selon l'une des revendications 19 à 31,
**caractérisé**
**en ce que** le dispositif comprend une rainure de guidage (44) s'étendant sensiblement sur le plan de transport (2) et le long de la voie de transport (4), les pinces (10) comprenant chacune un élément de guidage (42) réalisé de manière à être logé dans la rainure de guidage (44) pendant le déplacement des pinces (10) le long de la voie de transport (4).

33. Dispositif selon l'une des revendications 30 à 32,
**caractérisé**
**en ce que** les éléments de guidage (32a, 32b, 42) sont dimensionnés de telle manière que les éléments de guidage (32a, 32b, 42) de pinces (10) voisines soient sensiblement adjacents lorsque les pinces (10) se trouvent au niveau de la voie de transport (4).
